# EUROPEAN PATENT SPECIFICATION

(11) **EP 4 436 344 B1**
(45) Date of publication and mention of the grant of the patent: **09.12.2026**
(21) Application number: 24165499.5
(22) Date of filing: 22.03.2024
(51) Int. Cl.: H10K 59/131, H10K 59/13, H10K 77/10, H10K 102/00

(54) **DISPLAY APPARATUS**
ANZEIGEGERÄT
APPAREIL D'AFFICHAGE

(30) Priority: 24.03.2023 KR 20230039071; 29.03.2023 KR 20230041248
(43) Date of publication of application: 25.09.2024
(73) Proprietor: Samsung Display Co., Ltd., Yongin-si, Gyeonggi-do 17113 (KR)
(72) Inventor: Lee, Kyunghoe, 17113 Yongin-si, Gyeonggi-do (KR); Lee, Cheolgon, 17113 Yongin-si, Gyeonggi-do (KR); Jeon, Mukyung, 17113 Yongin-si, Gyeonggi-do (KR)
(74) Representative: Gulde & Partner

(56) References cited:
- CN-A- 112 837 655
- JP-B2- 4 632 742
- KR-A- 20220 072 914
- US-A1- 2019 043 420

## Description

### BACKGROUND

### 1. Field

One or more embodiments relate to a display apparatus.

### 2. Description of the Related Art

An organic photodiode (OPD) uses an organic semiconductor to absorb incident light and convert the incident light into an electric current. A structure of the OPD is very similar to a structure of an organic light-emitting diode (OLED). Each of the OPD and the OLED includes two electrodes facing each other and a photoactive layer or emission layer between the two electrodes. The OLED and the OPD may be arranged together in a display area of a display apparatus by using this structural similarity.

Lines configured to transfer electrical signals to be applied to the OLED and lines configured to transfer electrical signals generated by the OPD may be in a peripheral area outside the display area.

US 2019/043420 A1 relates to a display device including a photo pixel with improved sensing sensitivity built in a driving layer of a display panel. CN 112 837 655 A relates to a display panel capable of sensing external input and a display device including the display panel. KR 2022 0072914 A relates to a fingerprint sensor and a display device including the same.

### SUMMARY

In a display apparatus, as lines are densely arranged in a peripheral area, electrical interference, such as coupling capacitance or the like, may occur between the lines.

One or more embodiments include a display apparatus capable of displaying high-quality images by reducing electrical interference between lines. However, these are examples, and the scope of the disclosure is not limited thereto and being defined only by the appended claims.

Additional aspects will be set forth in part in the description which follows and, in part, will be apparent from the description, or may be learned by practice of the presented embodiments of the disclosure.

According to the claimed invention in independent claim 1, a display apparatus includes a substrate including a display area in which a light-emitting diode and a light sensor is arranged and a peripheral area outside the display area, data lines in the peripheral area, and light sensing signal lines including a first sub-signal line in the peripheral area, a third sub-signal line spaced apart from the first sub-signal line and positioned closer to the display area than the first sub-signal line, and a second sub-signal line connecting the first sub-signal line to the third sub-signal line, wherein, when viewed from a direction perpendicular to the substrate, the data lines are divided into a plurality of line groups, and the second sub-signal line is between the plurality of line groups, wherein the second sub-signal line is disposed in a different layer from the first sub-signal line and the third sub-signal line.

In an embodiment, the display apparatus may further include an interlayer insulating layer disposed on the data lines to cover the data lines, first power lines may be disposed on the interlayer insulating layer, and a first planarization layer may be arranged between the first power lines and the first sub-signal line to cover the first power lines.

In an embodiment, the first power lines may be between the first sub-signal line and the data lines in an area in which the first sub-signal line overlap the data lines.

In an embodiment, the substrate may include a bending area to bend the substrate so that a portion of the peripheral area overlaps the display area, and the first sub-signal line may cross the bending area.

In an embodiment, the display apparatus may further include a first planarization layer disposed on the data lines, wherein, when viewed from a direction perpendicular to the substrate, the substrate may include a valley area extending in a first direction parallel to a boundary of the display area, and the first planarization layer may have an opening overlapping the valley area.

In an embodiment, when viewed from a direction perpendicular to the substrate, the second sub-signal line may cross the valley area.

In an embodiment, the second sub-signal line may be disposed below the first planarization layer.

In an embodiment, the second sub-signal line may include a same material as each of the data lines.

In an embodiment, the display apparatus may further include an inorganic insulating layer below the data lines, wherein the second sub-signal line may be between the inorganic insulating layer and the substrate.

In an embodiment, the display apparatus may further include an interlayer insulating layer disposed on the data lines to cover the data lines, second power lines may be disposed on the interlayer insulating layer, and a first planarization layer between the second power lines and the third sub-signal line may cover the second power lines.

In an embodiment, the second power lines may be between the third sub-signal line and the data lines in an area in which the third sub-signal line overlap the data lines.

In an embodiment, the display apparatus may further include horizontal power lines arranged between the interlayer insulating layer and the first planarization layer and positioned closer to the display area than the second power lines, wherein the horizontal power lines may extend in a first direction parallel to a boundary of the display area, when viewed in a direction perpendicular to the substrate.

In an embodiment, the third sub-signal line may extend in a second direction perpendicular to the first direction in an area overlapping the horizontal power lines.

In an embodiment, the display apparatus may further include a second planarization layer disposed on the third sub-signal line to cover the third sub-signal line, and a shielding layer may be disposed on the second planarization layer.

In an embodiment, the shielding layer may be electrically connected to the second power lines.

In an embodiment, the shielding layer may overlap the third sub-signal line, when viewed from a direction perpendicular to the substrate.

In an embodiment, the display apparatus may further include dummy lines arranged between the plurality of line groups and which may include a same material as each of the data lines.

In an embodiment, a portion of the first sub-signal line, the portion overlapping the dummy lines, may extend in a direction parallel to the dummy lines, and another portion of the first sub-signal line, the other portion overlapping the data lines, may extend in a direction crossing the data lines.

In an embodiment, the dummy lines may be between the second sub-signal line and the data lines, when viewed from a direction perpendicular to the substrate.

In an embodiment, when viewed from a direction perpendicular to the substrate, the second sub-signal line may overlap the dummy lines, and the second sub-signal line may extend in a direction parallel to the dummy lines.

Other aspects, features, and advantages other than those described above will now become apparent from the following drawings, claims, and the detailed description of the disclosure.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a plan view schematically illustrating a display apparatus according to an embodiment;
FIG. 2 is a plan view schematically illustrating a portion of the display apparatus shown in FIG. 1;
FIGS. 3 and 4 are equivalent circuit diagrams of a pixel of a display apparatus according to an embodiment;
FIG. 5 is a cross-sectional view of a display apparatus according to an embodiment;
FIG. 6 is a cross-sectional view schematically illustrating a cross section of the display apparatus shown in FIG. 1, taken along a line I-I';
FIGS. 7 and 8 are plan views each schematically illustrating a portion of a display apparatus according to an embodiment;
FIG. 9 is a cross-sectional view schematically illustrating a cross section of the display apparatus shown in FIG. 8, take along a line IV-IV';
FIG. 10 is a cross-sectional view schematically illustrating a cross section of the display apparatus shown in FIG. 8, taken along a line V-V';
FIGS. 11, 12, and 13 are plan views each schematically illustrating a portion of a display apparatus according to an embodiment;
FIGS. 14 and 15 are plan views each schematically illustrating a portion of a display apparatus according to an embodiment;
FIG. 16 is a cross-sectional view schematically illustrating a portion of a display apparatus according to an embodiment; and
FIG. 17 is a cross-sectional view schematically illustrating a portion of a display apparatus according to another embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description.

As used herein, the word "or" means logical "or" so that, unless the context indicates otherwise, the expression "A, B, or C" means "A and B and C," "A and B but not C," "A and C but not B," "B and C but not A," "A but not B and not C," "B but not A and not C," and "C but not A and not B." Throughout the disclosure, the expression "at least one of a, b or c" indicates only a, only b, only c, both a and b, both a and c, both b and c, all of a, b, and c, or variations thereof.

As the disclosure allows for various changes and numerous embodiments, particular embodiments will be illustrated in the drawings and described in detail in the written description. Effects and features of the disclosure and methods of achieving the same will be apparent with reference to embodiments and drawings described below in detail. The disclosure may, however, be embodied in many different forms and should not be construed as being limited to the embodiments set forth herein.

The disclosure will now be described more fully with reference to the accompanying drawings, in which embodiments of the disclosure are shown. Like reference numerals in the drawings denote like elements, and thus their description will not be repeated.

In the disclosure, while such terms as "first," "second," etc., may be used to describe various elements, such elements must not be limited to the above terms.

In the disclosure, an expression used in the singular encompasses the expression of the plural, unless it has a clearly different meaning in the context.

In the disclosure, it is to be understood that the terms such as "comprising," "including" and "having" (and their variations such as "comprises") are intended to indicate the existence of the features, or elements disclosed in the present disclosure, and are not intended to preclude the possibility that one or more other features or elements may exist or may be added.

In the disclosure, it will be understood that when a layer, region, or component is referred to as being formed on another layer, region, or component, it can be directly or indirectly formed on the other layer, region, or component. That is, for example, intervening layers, regions, or components may be present.

In the disclosure, it will be understood that when a layer, region, or component is referred to as being connected to another layer, region, or component, it can be directly or indirectly connected to the other layer, region, or component. That is, for example, intervening layers, regions, or components may be present. For example, it will be understood that when a layer, region, or component is referred to as being electrically connected to another layer, region, or component, it can be directly or indirectly electrically connected to the other layer, region, or component. That is, for example, intervening layers, regions, or components may be present.

In the present disclosure, the x axis, the y axis, and the z axis are not limited to three rows on the orthogonal coordinates system, and may be interpreted in a broad sense including the same. For example, the x-axis, the y-axis, and the z-axis may be perpendicular to one another, or may represent different directions that are not perpendicular to one another.

In the disclosure, when a certain embodiment may be implemented differently, a specific process order may be performed differently from the described order. For example, two consecutively described processes may be performed substantially at the same time or performed in an order opposite to the described order.

Sizes of components in the drawings may be exaggerated for convenience of explanation. In other words, since sizes and thicknesses of components in the drawings are arbitrarily illustrated for convenience of explanation, the following embodiments are not limited thereto.

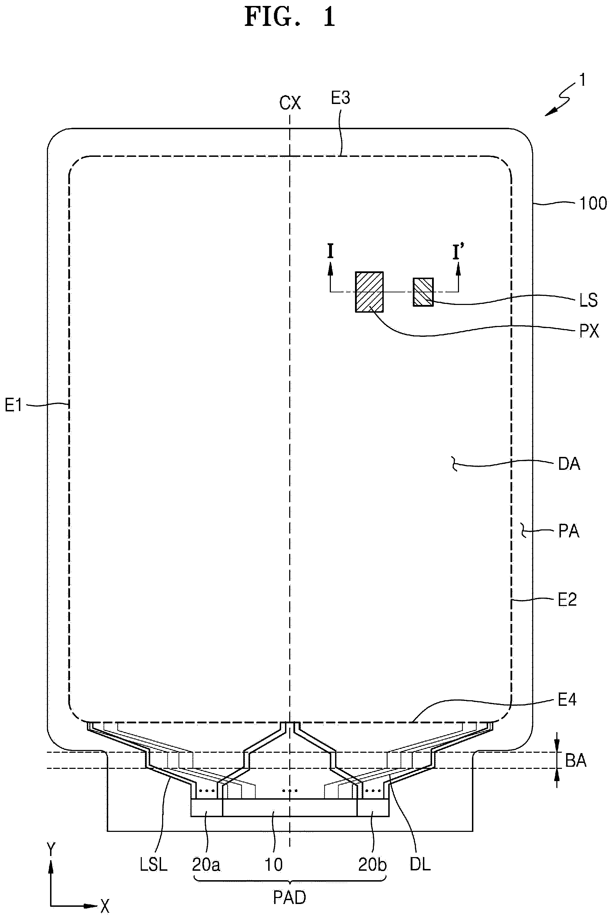

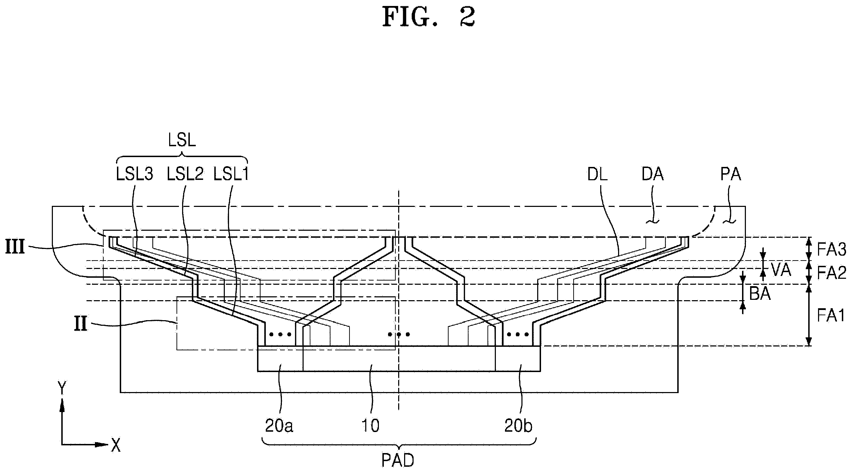

FIG. 1 is a plan view schematically illustrating a display apparatus according to an embodiment, and FIG. 2 is a plan view schematically illustrating a portion of the display apparatus shown in FIG. 1. For reference, FIG. 2 may be a plan view illustrating an enlarged lower portion of the display apparatus shown in FIG. 1.

Referring to FIG. 1, a display apparatus 1 according to the claimed invention includes a display area DA and a peripheral area PA outside the display area DA. The display apparatus 1 including the display area DA and the peripheral area PA is understood that a substrate 100 of the display apparatus 1 includes the display area DA and the peripheral area PA.

The substrate 100 may include various materials, which are flexible (such as bendable or rollable). For example, the substrate 100 may include a polymer resin, such as polyethersulfone, polyacrylate, polyetherimide, polyethylene naphthalate, polyethylene terephthalate, polyphenylene sulfide, polyarylate, polyimide, polycarbonate, or cellulose acetate propionate.

Various modifications may be made, for example, the substrate 100 may include two layers each including the polymer resin and a barrier layer between the two layers, the barrier layer including an inorganic material, such as silicon oxide (SiOₓ), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), zinc oxide (ZnO), or the like.

A plurality of pixels PX and a plurality of light sensors LS are arranged in the display area DA. A pad unit PAD to which various electronic devices, such as an integrated circuit (IC), or a printed circuit board are electrically attached may be arranged in the peripheral area PA.

In the disclosure, each of the plurality of pixels PX is a minimum unit for displaying an image, and may be a sub-pixel emitting light of a certain color. For example, the pixel PX may emit, red, green, or blue light. Each pixel PX may include a display element such as an organic light-emitting diode, and the display element may be connected to a pixel circuit including a thin-film transistor or the like.

Each of the plurality of light sensors LS is a minimum unit for obtaining image information or the like by sensing light, and may be between pixels PX. For example, the light sensor LS may generate an electrical signal by sensing light emitted by the pixels PX and reflected by an object adjacent to the display apparatus 1. The light sensor LS may include a light receiving element, such as an organic photodiode, and the light receiving element may be connected to a sensing circuit including a thin-film transistor.

An edge of the display area DA may have a rectangular shape as a whole. For example, the display area DA may include a first edge E1 and a second edge E2, which opposite each other, and a third edge E3 and a fourth edge E4, which opposite each other and are between the first edge E1 and the second edge E2.

The pad unit PAD may be arranged in the peripheral area PA adjacent to the fourth edge E4 of the display area DA. The pad unit PAD may include a first pad unit 10, a second pad unit 20a arranged on one side of the first pad unit 10 (in an -x direction), and a third pad unit 20b arranged on another side of the first pad unit 10 (in a +x direction).

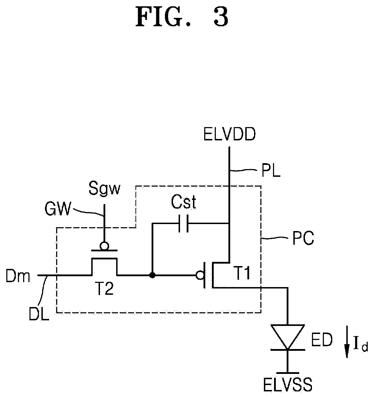

A plurality of lines are arranged in the peripheral area PA adjacent to the pad unit PAD. The plurality of lines includes a data line DL configured to transfer electrical signals to be applied to the pixels PX in the display area DA, and a light sensing signal line LSL configured to receive electrical signals sensed by the light sensors LS in the display area DA. Although not illustrated in FIGS. 1 and 2, power lines configured to transfer a common voltage ELVSS (refer to FIG. 3) or the like, which is an electrostatic voltage, to each pixel PX may be arranged in the peripheral area PA adjacent to the pad unit PAD.

Data lines DL may be electrically connected to the first pad unit 10 of the pad unit PAD. To this end, ends of the data lines DL (in a -y direction) adjacent to the pad unit PAD may be positioned adjacent to each other. Also, other ends of the data lines DL (in a +y direction) may be positioned to be relatively spaced apart from each other, as compared with the ends of the data lines DL (in the -y direction). This is due to the positions of the pixels PX receiving electrical signals transferred by the data lines DL.

The light sensing signal lines LSL may be electrically connected to the second pad unit 20a and the third pad unit 20b of the pad unit PAD. When viewed from a direction perpendicular to the substrate 100, the light sensors LS arranged on one side of the display area DA (in the -x direction) based on a central axis CX passing through a center of the display area DA and extending in a y-axis direction may be electrically connected to the second pad unit 20a through the light sensing signal line LSL. Similarly, the light sensors LS arranged on another side of the display area DA (in the +x direction) based on the central axis CX may be electrically connected to the third pad unit 20b through the light sensing signal line LSL. To this end, ends of the light sensing signal lines LSL (in the -y direction) adjacent to the pad unit PAD may be positioned adjacent to each other. Also, other ends of the light sensing signal lines LSL (in the +y direction) may be positioned to be relatively spaced apart from each other, as compared with the ends of the light sensing signal lines LSL (in the -y direction).

When viewed from a direction perpendicular to the substrate 100, the data lines DL and the light sensing signal lines LSL are arranged to overlap each other in the peripheral area PA.

FIG. 1 may also be understood as a plan view illustrating an appearance of a substrate of the like during a manufacturing process. In the final display apparatus 1 or an electronic device, such as a smartphone including the display apparatus 1, a portion of the substrate 100 or the like may be bent to minimize the area of the peripheral area PA recognized by a user. For example, the peripheral area PA may include a bending area BA between the pad unit PAD and the display area DA. The substrate 100 may be bent at the bending area BA, so that at least a portion of the peripheral area PA, in which the pad unit PAD is positioned, may be positioned to overlap the display area DA. Accordingly, the user recognizes that the display area DA occupies most of the portions of the display apparatus 1.

Referring to FIG. 2, the peripheral area PA may include a first fan-out area FA1, a second fan-out area FA2, and a third fan-out area FA3, which are between the pad unit PAD and the display area DA. The first fan-out area FA1 may be in contact with a boundary of the pad unit PAD, the third fan-out area FA3 may be in contact with a boundary of the display area DA, and the second fan-out area FA2 may be between the first fan-out area FA1 and the third fan-out area FA3.

When viewed from a direction perpendicular to the substrate 100, the first fan-out area FA1 may overlap the bending area BA. In other words, the first fan-out area FA1 may be defined as an area from an upper boundary of the pad unit PAD (in the +y direction) to an upper boundary of the bending area BA (in the +y direction).

When viewed from a direction perpendicular to the substrate 100, the second fan-out area FA2 may overlap a valley area VA from which a portion of an organic insulating layer is removed. That is, the second fan-out area FA2 may be defined as an area from the upper boundary of the bending area BA (in the +y direction) to an upper boundary of the valley area VA (in the +y direction).

The third fan-out area FA3 may be defined as an area from the upper boundary of the valley area VA (in the +y direction) the fourth edge E4 of the display area DA.

The data line DL may extend from the first pad unit 10 to the display area DA. In other words, the data line DL may extend from the first fan-out area FA1 to the third fan-out area FA3 via the second fan-out area FA2.

The light sensing signal line LSL may extend from the second pad unit 20a and the third pad unit 20b to the display area DA. The light sensing signal line LSL may extend from the first fan-out area FA1 to the third fan-out area FA3 via the second fan-out area FA2.

Each light sensing signal line LSL includes a first sub-signal line LSL1 in the first fan-out area FA1, a second sub-signal line LSL2 in the second fan-out area FA2, and a third sub-signal line LSL3 in the third fan-out area FA3. The third sub-signal line LSL3 is positioned closer to the display area DA than the first sub-signal line LSL1. The second sub-signal line LSL2 is between the first sub-signal line LSL1 and the third sub-signal line LSL3 and coonects the first sub-signal line LSL1 to the third sub-signal line LSL3.

The first sub-signal line LSL1 is disposed on a different layer from that of the second sub-signal line LSL2. Similarly, the third sub-signal line LSL3 is disposed on a different layer from that of the second sub-signal line LSL2.

An end of the first sub-signal line LSL1 (in the -y direction) may be electrically connected to the second pad unit 20a or the third pad unit 20b. In an embodiment, a pad including the second pad unit 20a or the third pad unit 20b may be integrally formed with the first sub-signal line LSL1. Another end of the first sub-signal line LSL1 (in the +y direction) may be electrically connected to an end of the second sub-signal line LSL2 (in the -y direction). Another end of the second sub-signal line LSL2 (in the +y direction) may be electrically connected to an end of the third sub-signal line LSL3 (in the -y direction). Another end of the third sub-signal line LSL3 (in the +y direction) may extend into the display area DA.

That is, the first sub-signal line LSL1, the second sub-signal line LSL2, and the third sub-signal line LSL3 are electrically connected to each other to function as the light sensing signal line LSL configured to transfer a light sensing signal from a light sensor LS of a corresponding column in the display area DA to an integrated device or the like.

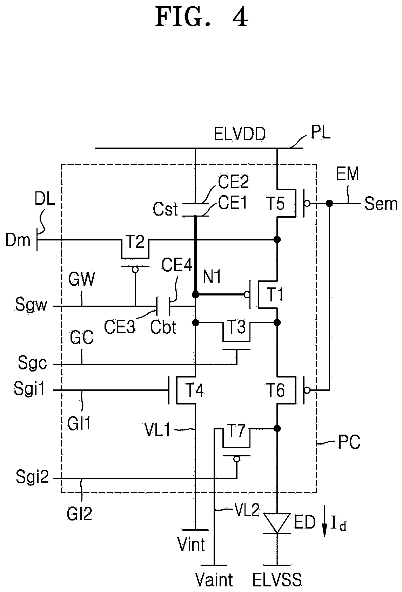

FIGS. 3 and 4 are equivalent circuit diagrams of a pixel of a display apparatus according to an embodiment.

Referring to FIG. 3, a light-emitting diode ED may be electrically connected to a pixel circuit PC, and the pixel circuit PC may include a first transistor T1, a second transistor T2, and a storage capacitor Cst.

The second transistor T2 may be configured to transfer, to the first transistor T1, a data signal Dm input through the data line DL according to a scan signal Sgw input through a scan line GW.

The storage capacitor Cst is connected to the second transistor T2 and a driving voltage line PL and stores a voltage corresponding to a difference between a voltage received from the second transistor T2 and a driving voltage ELVDD supplied to the driving voltage line PL.

The first transistor T1 may be connected to the driving voltage line PL and the storage capacitor Cst, and may control a driving current I_{d} flowing from the driving voltage line PL to the light-emitting diode ED, in accordance to a voltage value stored in the storage capacitor Cst. An opposite electrode (e.g., a cathode) of the light-emitting diode ED may receive a common voltage ELVSS. The light-emitting diode ED may emit light having a certain brightness according to the driving current I_{d}.

Although FIG. 3 illustrates that the pixel circuit PC includes two transistors and one storage capacitor, the disclosure is not limited thereto.

Referring to FIG. 4, the pixel circuit PC may include seven transistors and two capacitors.

The pixel circuit PC may include first to seventh transistors T1, T2, T3, T4, T5, T6, and T7, a storage capacitor Cst, and a boost capacitor Cbt. In another embodiment, the pixel circuit PC may not include the boost capacitor Cbt.

Some of the first to seventh transistors T1, T2, T3, T4, T5, T6, and T7 may be N-channel metal-oxide-semiconductor field-effect transistors (MOSFET) (NMOS), and the remaining may be P-channel MOSFETs (PMOS). In an embodiment, the third and fourth transistors T3 and T4 may be N-channel metal-oxide-semiconductor field-effect transistors (MOSFET) (NMOS), and the remaining transistors may be P-channel MOSFETs (PMOS).

The first to seventh transistors T1, T2, T3, T4, T5, T6, and T7, the storage capacitor Cst, and the boost capacitor Cbt may be connected to a signal line. A signal line may include the scan line GW, an emission control line EM, a compensation gate line GC, a first initialization gate line GI1, a second initialization gate line GI2, and the data line DL. The pixel circuit PC may be electrically connected to a voltage line, for example, the driving voltage line PL, a first initialization voltage line VL1, and a second initialization voltage line VL2.

The first transistor T1 may be a driving transistor. A first gate electrode of the first transistor T1 may be connected to a lower electrode CE1 of the storage capacitor Cst, a first electrode of the first transistor T1 may be electrically connected to the driving voltage line PL via the fifth transistor T5, and a second electrode of the first transistor T1 may be electrically connected to a first electrode (e.g., an anode) of the light-emitting diode ED via the sixth transistor T6. One of the first electrode and the second electrode of the first transistor T1 may be a source electrode, and the other one may be a drain electrode. The first transistor T1 may supply the driving current I_{d} to the light-emitting diode ED according to a switching operation of the second transistor T2.

The second transistor T2 may be a switching transistor. A second gate electrode of the second transistor T2 may be connected to the scan line GW, a first electrode of the second transistor T2 may be connected to the data line DL, and a second electrode of the second transistor T2 may be electrically connected to the driving voltage line PL via the fifth transistor T5 while being connected to the first electrode of the first transistor T1. One of the first electrode and the second electrode of the second transistor T2 may be a source electrode, and the other one may be a drain electrode. The second transistor T2 may be turned on according to the scan signal Sgw received through the scan line GW, and may perform a switching operation of transferring the data signal Dm transferred to the data line DL to the first electrode of the first transistor T1.

The third transistor T3 may be a compensation transistor that compensates for a threshold voltage of the first transistor T1. A third gate electrode of the third transistor T3 is connected to the compensation gate line GC. A first electrode of the third transistor T3 is connected to a lower electrode CE1 of the storage capacitor Cst and the first gate electrode of the first transistor T1. The first electrode of the third transistor T3 may be connected to the fourth transistor T4. A second electrode of the third transistor T3 is electrically connected to the first electrode (e.g., an anode) of the light-emitting diode ED via the sixth transistor T6 while being connected to the second electrode of the first transistor T1. One of the first electrode and the second electrode of the third transistor T3 may be a source electrode, and the other one may be a drain electrode.

The third transistor T3 is turned on according to a compensation signal Sgc received through the compensation gate line GC to electrically connect the first gate electrode and the second electrode (e.g., a drain electrode) of the first transistor T1 to each other to diode-connect the first transistor T1.

The fourth transistor T4 may be a first initialization transistor that initializes the first gate electrode of the first transistor T1. A fourth gate electrode of the fourth transistor T4 is connected to the first initialization gate line GI1. A first electrode of the fourth transistor T4 is connected to the first initialization voltage line VL1. A second electrode of the fourth transistor T4 may be connected to the lower electrode CE1 of the storage capacitor Cst, the first electrode of the third transistor T3, and the first gate electrode of the first transistor T1. One of the first electrode and the second electrode of the fourth transistor T4 may be a source electrode, and the other one may be a drain electrode. The fourth transistor T4 may be turned on according to a first initialization signal Sgi1 received through the first initialization gate line GI1 to be configured to transfer a first initialization voltage Vint to the first gate electrode of the first transistor T1 to perform an initialization operation of initializing a voltage of the first gate electrode of the first transistor T1.

The fifth transistor T5 may be an operation control transistor. A fifth gate electrode of the fifth transistor T5 is connected to the emission control line EM, a first electrode of the fifth transistor T5 is connected to the driving voltage line PL, and a second electrode of the fifth transistor T5 is connected to the first electrode of the first transistor T1 and the second electrode of the second transistor T2. One of the first electrode and the second electrode of the fifth transistor T5 may be a source electrode, and the other one may be a drain electrode.

The sixth transistor T6 may be an emission control transistor. A sixth gate electrode of the sixth transistor T6 is connected to the emission control line EM, a first electrode of the sixth transistor T6 is connected to the second electrode of the first transistor T1 and the second electrode of the third transistor T3, and a second electrode of the sixth transistor T6 is electrically connected to a second electrode of the seventh transistor T7 and the first electrode (e.g., an anode) of the light-emitting diode ED. One of the first electrode and the second electrode of the sixth transistor T6 may be a source electrode, and the other one may be a drain electrode.

The fifth transistor T5 and the sixth transistor T6 are simultaneously turned on according to an emission control signal Sem received through the emission control line EM to allow the driving voltage ELVDD to be transferred to the light-emitting diode ED, and the driving current I_{d} may flow through the light-emitting diode ED.

The seventh transistor T7 may be a second initialization transistor that initializes the first electrode (e.g., an anode) of the light-emitting diode ED. A seventh gate electrode of the seventh transistor T7 is connected to the second initialization gate line GI2. A first electrode of the seventh transistor T7 is connected to the second initialization voltage line VL2. A second electrode of the seventh transistor T7 is connected to the second electrode of the sixth transistor T6 and the first electrode (e.g., an anode) of the light-emitting diode ED. One of the first electrode and the second electrode of the seventh transistor T7 may be a source electrode, and the other one may be a drain electrode. The seventh transistor T7 is turned on according to a second initialization signal Sgi2 received through the second initialization gate line GI2, and may be configured to transfer a second initialization voltage Vaint to the first electrode (e.g., an anode) of the light-emitting diode ED to initialize the first electrode of the light-emitting diode ED.

In some embodiments, the second initialization gate line GI2 may be a subsequent scan line. For example, the second initialization gate line GI2 connected to a seventh transistor T7 of a pixel circuit PC arranged in the i-th row (wherein i is a natural number) may correspond to a scan line of a pixel circuit PC arranged in the (i+1)-th row. In another embodiment, the second initialization gate line GI2 may be the emission control line EM. For example, the emission control line EM may be electrically connected to the fifth to seventh transistors T5, T6, and T7.

The storage capacitor Cst includes the lower electrode CE1 and an upper electrode CE2. The lower electrode CE1 of the storage capacitor Cst is connected to the first gate electrode of the first transistor T1, and the upper electrode CE2 of the storage capacitor Cst is connected to the driving voltage line PL. The storage capacitor Cst may store a charge corresponding to a difference between a voltage of the first gate electrode of the first transistor T1 and the driving voltage ELVDD.

The boost capacitor Cbt includes a third electrode CE3 and a fourth electrode CE4. The third electrode CE3 may be connected to the second gate electrode of the second transistor T2 and the scan line GW, and the fourth electrode CE4 may be connected to the first electrode of the third transistor T3 and the first node N1. When the scan signal Sgw supplied to the scan line GW is turned off, the boost capacitor Cbt may increase a voltage of a first node N1, and when the voltage of the first node N1 is increased, a black gradation may be clearly expressed.

The first node N1 may be an area to which the first gate electrode of the first transistor T1, the first electrode of the third transistor T3, the second electrode of the fourth transistor T4, and the fourth electrode CE4 of the boost capacitor Cbt are connected.

In an embodiment, the third and fourth transistors T3 and T4 are NMOSs, and the first, second, and fifth to seventh transistors T1, T2, T5, T6, and T7 are PMOSs. The first transistor T1, which directly affects the brightness of a display apparatus displaying images, may be configured to include a semiconductor layer including polycrystalline silicon having high reliability, thereby implementing a display apparatus having high resolution.

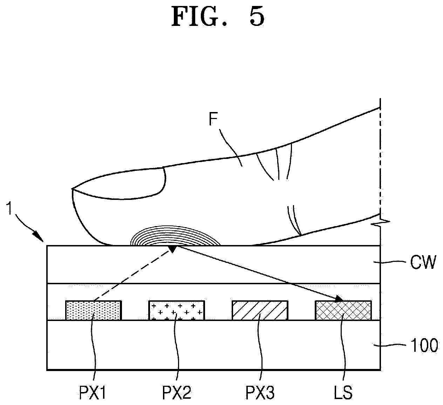

FIG. 5 is a cross-sectional view of a display apparatus according to an embodiment.

Referring to FIG. 5, the display apparatus 1 according to an embodiment may include the substrate 100, a first pixel PX1, a second pixel PX2, a third pixel PX3, and a light sensor LS, which are disposed on the substrate 100, and a cover window CW.

Each of the first pixel PX1, the second pixel PX2, and the third pixel PX3 may include a display element such as an organic light-emitting diode, and the light sensor LS may include a light receiving element such as an organic photodiode.

In an embodiment, the first pixel PX1, the second pixel PX2, and the third pixel PX3 may emit light of different colors. For example, the first pixel PX1 may emit first color light, the second pixel PX2 may emit second color light, and the third pixel PX3 may emit third color light. At this time, the first color light, the second color light, and the third color light may respectively be red light, green light, and blue light, but the disclosure is not limited thereto.

The display apparatus 1 may sense an object in contact with the cover window CW, for example, a fingerprint of a finger F. In an embodiment, light emitted by at least one of the first pixel PX1, the second pixel PX2, and the third pixel PX3 may be reflected by the fingerprint of the user to be re-incident to the light sensor LS. The light sensor LS may sense reflected light and convert the same to an electrical signal. For example, the first color light emitted by the first pixel PX1 is reflected by the fingerprint of the finger F in contact with the cover window CW to be re-incident to the light sensor LS, so that the light sensor LS may obtain a fingerprint pattern of the finger F.

FIG. 5 shows an example of obtaining information of an object in contact with the display apparatus 1 by using reflection of light emitted by the first pixel PX1, but the disclosure is not limited thereto. The display apparatus 1 may also sense an object which is not in contact with the cover window CW of the display apparatus 1.

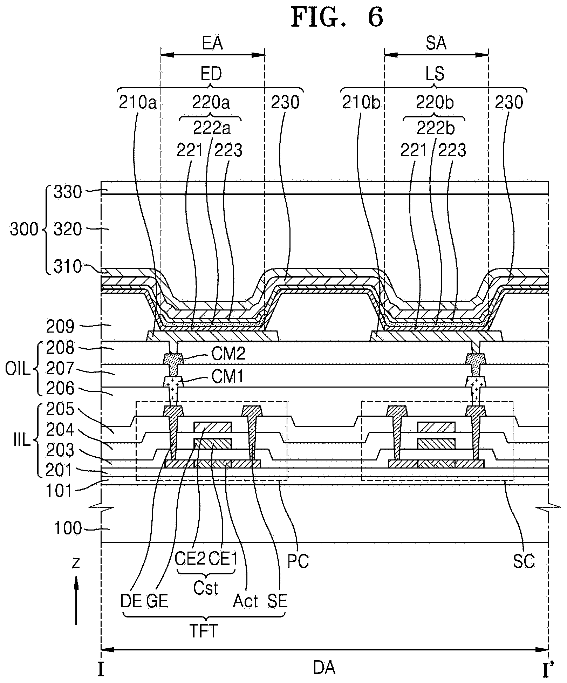

FIG. 6 is a cross-sectional view schematically illustrating a cross section of the display apparatus shown in FIG. 1, taken along a line I-I'.

Referring to FIG. 6, the display apparatus 1 (refer to FIG. 1) according to an embodiment may include the substrate 100.

The substrate 100 may include the display area DA, the light-emitting diode ED, the light sensor LS, the pixel circuit PC electrically connected to the light-emitting diode ED, and a sensing circuit SC electrically connected to the light sensor LS may be arranged in the display area DA. As described above, one pixel PX (refer to FIG. 1) may include the light-emitting diode ED and the pixel circuit PC electrically connected to the light-emitting diode ED. The light sensor LS is a light receiving element, and may be an organic photodiode.

A barrier layer 101 may be disposed on the substrate 100. The barrier layer 101 may include an inorganic insulating material, such as silicon nitride, silicon oxide, or silicon oxynitride.

A buffer layer 201 may be disposed on the barrier layer 101. The barrier layer 101 and the buffer layer 201 may reduce or block penetration of foreign materials, moisture, or external air from a lower portion of the substrate 100, and may provide a flat surface on the substrate 100. The buffer layer 201 may include an inorganic material, such as silicon nitride, silicon oxide, or silicon oxynitride, an organic material, or an organic/inorganic composite.

The pixel circuit PC may be disposed on the buffer layer 201. The pixel circuit PC may include a thin-film transistor TFT and the storage capacitor Cst. The thin-film transistor TFT may include a semiconductor layer Act, a gate electrode GE, a source electrode SE, and a drain electrode DE, and the storage capacitor Cst may include the lower electrode CE1 and the upper electrode CE2.

The semiconductor layer Act may be disposed on the buffer layer 201. The semiconductor layer Act may include polysilicon. Alternatively, the semiconductor layer Act may include amorphous silicon, an oxide semiconductor, an organic semiconductor, or the like. The semiconductor layer Act may include a channel area, a drain area, and a source area, the drain area and the source area being respectively arranged on both sides of the channel area.

The gate electrode GE may be disposed above the semiconductor layer Act. The gate electrode GE may overlap the channel area of the semiconductor layer Act. The gate electrode GE may include a low-resistance metal material. The gate electrode GE may include a conductive material including molybdenum (Mo), aluminum (Al), copper (Cu), titanium (Ti), or the like, and may include a single layer or a multi-layer, each including the above material.

A first gate insulating layer 203 may be between the semiconductor layer Act and the gate electrode GE. The first gate insulating layer 203 may include an inorganic insulating material, such as silicon oxide, silicon nitride, silicon oxynitride, aluminum oxide, titanium oxide, tantalum oxide, hafnium oxide, zinc oxide. The first gate insulating layer 203 may include a single layer or a multi-layer, each including the above inorganic insulating material.

A second gate insulating layer 204 may be disposed on the gate electrode GE to cover the gate electrode GE. The second gate insulating layer 204 may include an inorganic insulating material, such as silicon oxide, silicon nitride, silicon oxynitride, aluminum oxide, titanium oxide, tantalum oxide, hafnium oxide, zinc oxide. The second gate insulating layer 204 may include a single layer or a multi-layer, each including the above inorganic insulating material.

The upper electrode CE2 of the storage capacitor Cst may be disposed on the second gate insulating layer 204. At least a portion of the upper electrode CE2 may overlap the gate electrode GE, and the gate electrode GE may function as the lower electrode CE1 of the storage capacitor Cst. For example, the gate electrode GE may be integrally formed with the lower electrode CE1.

The upper electrode CE2 may include a conductive material including Mo, Al, Cu, Ti, or the like, and may include a single layer or a multi-layer, each including the above material.

An interlayer insulating layer 205 may be disposed on the upper electrode CE2. The interlayer insulating layer 205 may be formed to cover the upper electrode CE2, and may include an inorganic insulating material such as silicon oxide, silicon nitride, silicon oxynitride, or the like. The interlayer insulating layer 205 may include a single layer or a multi-layer, each including the above inorganic insulating material. In the disclosure, an inorganic insulating layer IIL may include the buffer layer 201, the first gate insulating layer 203, the second gate insulating layer 204 and the interlayer insulating layer 205.

The source electrode SE and the drain electrode DE are disposed on the interlayer insulating layer 205. The source electrode SE and the drain electrode DE may each include a conductive material including Mo, Al, Cu, Ti, or the like, and may include a multi-layer or a single layer, each including the above material. For example, each of the source electrode SE and the drain electrode DE may include a multi-layered structure of Ti/Al/Ti. In some embodiments, the source electrode SE or the drain electrode DE may be omitted. For example, thin-film transistors TFT, which are adjacent to each other, may share a source area or a drain area of the semiconductor layer Act, and the source area or the drain area may function as the source electrode SE or the drain electrode DE.

The sensing circuit SC may include a thin-film transistor or the like. Because the thin-film transistor of the sensing circuit SC has a similar structure as that of the thin-film transistor TFT of the pixel circuit PC, descriptions of the sensing circuit SC already given with reference to the descriptions of the pixel circuit PC are omitted.

A first planarization layer 206, a second planarization layer 207, and a third planarization layer 208 may be sequentially stacked in a thickness direction (a z axis direction) of the display apparatus 1 to cover the source electrode SE and the drain electrode DE of the pixel circuit PC. The first planarization layer 206, the second planarization layer 207, and the third planarization layer 208 may each have a flat upper surface, so that a first electrode 210a of the light-emitting diode ED and a second electrode 210b of the light sensor LS, which are disposed thereon, may be formed flat.

The first planarization layer 206, the second planarization layer 207, and the third planarization layer 208 may each include an organic insulating material, such as benzocyclobutene (BCB), hexamethyldisiloxane (HMDSO), polymethylmethacrylate (PMMA), a general commercial polymer such as polystyrene (PS), a polymer derivative having a phenol group, an acrylic polymer, an imide polymer, such as polyimide, an aryl ether polymer, an amide polymer, a fluorine polymer, a p-xylene polymer, a vinyl alcohol polymer, or the like. Each of the first planarization layer 206, the second planarization layer 207, and the third planarization layer 208 may include a single layer or a multi-layer, each including the above organic insulating material.

A first connection electrode CM1 may be between the first planarization layer 206 and the second planarization layer 207, and a second connection electrode CM2 may be between the second planarization layer 207 and the third planarization layer 208. The first connection electrode CM1 may be connected to the drain electrode DE of the thin-film transistor TFT of the pixel circuit PC through a contact hole defined in the first planarization layer 206. The second connection electrode CM2 may be connected to the first connection electrode CM1 through a contact hole defined in the second planarization layer 207.

The first connection electrode CM1 and the second connection electrode CM2 may each include a conductive material including Mo, Al, Cu, Ti, or the like, and may include a single layer or a multi-layer, each including the above material.

An organic insulating layer OIL shown in FIG. 6 includes the first planarization layer 206, the second planarization layer 207, and the third planarization layer 208, but the disclosure is not limited thereto. For example, the organic insulating layer OIL between the source electrode SE and drain electrode DE and the first electrode 210a may further include one or more planarization layers. In this case, a connection electrode may be provided between each of the organic layers to electrically connect the first electrode 210a of the light-emitting diode ED to the drain electrode DE of the thin-film transistor TFT. Similarly, a connection electrode may be provided between each of the organic layers to electrically connect the second electrode 210b of the light sensor LS to the thin-film transistor of the sensing circuit SC.

The light-emitting diode ED and the light sensor LS may be disposed on the third planarization layer 208. The light-emitting diode ED may include the first electrode 210a, an opposite electrode 230, and a first intermediate layer 220a between the first electrode 210a and the opposite electrode 230. The light sensor LS may include the second electrode 210b, the opposite electrode 230, and a second intermediate layer 220b between the second electrode 210b and the opposite electrode 230. Here, the opposite electrode 230 of the light-emitting diode ED and the opposite electrode 230 of the light sensor LS may be integrally provided over the light-emitting diode ED and the light sensor LS.

The first electrode 210a and the second electrode 210b may be disposed on the third planarization layer 208 to be spaced apart from each other. Because the second electrode 210b has the same structure as that of the first electrode 210a, the first electrode 210a is mainly described below. The first electrode 210a may be electrically connected to the second connection electrode CM2 through a contact hole defined in the third planarization layer 208.

The first electrode 210a may include a conductive oxide, such as indium tin oxide (ITO), indium zinc oxide (IZO), zinc oxide (ZnO), indium oxide (In₂O₃), indium gallium oxide (IGO), or aluminum zinc oxide (AZO). The first electrode 210a may include a reflective film including silver (Ag), magnesium (Mg), aluminum (Al), platinum (Pt), palladium (Pd), gold (Au), nickel (Ni), neodymium (Nd), iridium (Ir), chromium (Cr), or a compound thereof. For example, the first electrode 210a may have a structure having films including ITO, IZO, ZnO, or In₂O₃ formed above/below the above-stated reflective film. In this case, the first electrode 210a may have a stacked structure of ITO/Ag/ITO.

A pixel defining layer 209 may be disposed on the third planarization layer 208 to cover an edge of each of the first electrode 210a and the second electrode 210b. The pixel defining layer 209 may have a first opening exposing a central portion of the first electrode 210a and a second opening exposing a central portion of the second electrode 210b. The size and shape of an emission area EA of the light-emitting diode ED may be defined by the first opening exposing the central portion of the first electrode 210a. The size and shape of a sensing area SA of the light sensor LS may be defined by the second opening exposing the central portion of the second electrode 210b.

The pixel defining layer 209 may prevent an arc or the like from being generated at the edge of the first electrode 210a and the edge of the second electrode 210b by increasing a distance between the edge of the first electrode 210a and the opposite electrode 230 and a distance between the edge of the second electrode 210b and the opposite electrode 230. The pixel defining layer 209 may be formed of an organic insulating material, such as polyimide, polyamide, an acrylic resin, BCB, HMDSO, and a phenol resin, in a spin coating method or the like.

The first intermediate layer 220a may be disposed on the first electrode 210a, and the second intermediate layer 220b may be disposed on the second electrode 210b.

The first intermediate layer 220a may include an emission layer 222a arranged to correspond to the first opening of the pixel defining layer 209, and a first functional layer 221 and a second functional layer 223, which are respectively disposed below or on the emission layer 222a. The second intermediate layer 220b may include an active layer 222b arranged to correspond to the second opening of the pixel defining layer 209, and the first functional layer 221 and the second functional layer 223, which are respectively disposed below or on the active layer 222b.

The emission layer 222a may an organic material including a fluorescent material or a phosphorescent material emitting red, green, blue, or white light. The emission layer 222a may be an organic emission layer including a low-molecular-weight organic material or a polymer organic material. For example, the emission layer 222a is an organic emission layer, and may include copper phthalocyanine, tris(8-hydroxyquinoline) aluminum, a poly-phenylenevinylene (PPV)-based material, or a polyfluorene-based material.

In an embodiment, the emission layer 222a may include a host material and a dopant material. The dopant material is a material that emits light of a particular color, and may include a light-emitting material. The light-emitting material may include at least one of a phosphorescent dopant, a fluorescent dopant, and quantum dots.

The active layer 222b may include a p-type organic semiconductor and an n-type organic semiconductor. At this time, the p-type organic semiconductor may act as an electron donor, and the n-type organic semiconductor may act as an electron acceptor.

In an embodiment, the active layer 222b may be a mixed layer in which the p-type organic semiconductor and the n-type organic semiconductor are mixed. In this case, the active layer 222b may be formed by co-depositing the p-type organic semiconductor and the n-type organic semiconductor. When the active layer 222b is a mixed layer, excitons may be generated within a diffusion length from a donor-acceptor interface.

In an embodiment, the p-type organic semiconductor may be a compound that acts as an electron donor supplying electrons. For example, the p-type semiconductor may include boron subphthalocyanine chloride (SubPc), copper (II) phthalocyanine (CuPc), tetraphenyldibenzoperiflanthene (DBP), or any combination thereof, but is not limited thereto.

In an embodiment, the n-type organic semiconductor may be a compound that acts as an electron acceptor accepting electrons. For example, the n-type organic semiconductor may include C60 fullerene, C70 fullerene, or any combination thereof, but is not limited thereto.

The first functional layer 221 and the second functional layer 223 may be integrally provided over an entire surface of the display area DA. That is, the first functional layer 221 of the first intermediate layer 220a of the light-emitting diode ED may be integrally provided with the first functional layer 221 of the second intermediate layer 220b of the light sensor LS, and the second functional layer 223 of the first intermediate layer 220a of the light-emitting diode ED may be integrally provided with the second functional layer 223 of the second intermediate layer 220b of the light sensor LS.

In an embodiment, the first functional layer 221 may include at least one of a hole injection layer, a hole transport layer, and an electron blocking layer. The first functional layer 221 may have a single-layered structure or a multi-layered structure. When the first functional layer 221 has a multi-layered structure, the first functional layer 221 may include a hole injection layer and a hole transport layer, a hole injection layer and an electron blocking layer, a hole transport layer and an electron blocking layer, or a hole injection layer, a hole transport layer, and an electron blocking layer, the layers being sequentially stacked in the thickness direction (the z axis direction) of the display apparatus 1. However, the disclosure is not limited thereto.

In an embodiment, the second functional layer 223 may include at least one of an electron injection layer, an electron transport layer, and a hole blocking layer. The second functional layer 223 may have a single-layered structure or a multi-layered structure. When the second functional layer 223 has a multi-layered structure, the second functional layer 223 may include an electron transport layer and an electron injection layer, a hole blocking layer and an electron injection layer, a hole blocking layer and an electron transport layer, or a hole blocking layer, an electron transport layer, and an electron injection layer, the layers being sequentially stacked in the thickness direction (the z axis direction) of the display apparatus 1. However, the disclosure is not limited thereto.

In an embodiment, the first intermediate layer 220a may have a single-stacked structure including a single emission layer, or may have a tandem structure, which is a multi-stacked structure including a plurality of emission layers. When the first intermediate layer 220a has a tandem structure, a charge generation layer may be arranged between adjacent stacks of the multi-stacked structure.

The opposite electrode 230 may be disposed on the first intermediate layer 220a and the second intermediate layer 220b. The opposite electrode 230 may be integrally provided over an entire surface of the display area DA.

The opposite electrode 230 may include a conductive material having a relatively low work function. For example, the opposite electrode 230 may include a (semi)transparent layer including Ag, Mg, Al, Ni, Cr, lithium (Li), calcium (Ca), alloys thereof, or the like. Alternatively, the opposite electrode 230 may further include a layer, such as a layer including ITO, IZO, ZnO, or In₂O₃, above the (semi)transparent layer including the materials stated above. In an embodiment, the opposite electrode 230 may include Ag and Mg.

An encapsulation layer 300 may be disposed on the opposite electrode 230 to cover the light-emitting diode ED and the light sensor LS. In an embodiment, the encapsulation layer 300 may include at least one inorganic encapsulation layer and at least one organic encapsulation layer. For example, the encapsulation layer 300 may include first and second inorganic encapsulation layers 310 and 330, and an organic encapsulation layer 320 therebetween.

Each of the first and second inorganic encapsulation layers 310 and 330 may include one or more inorganic insulating materials. The inorganic insulating material may include silicon oxide, silicon nitride, or silicon oxynitride. The first and second inorganic encapsulation layers 310 and 330 may be formed through chemical vapor deposition.

The organic encapsulation layer 320 may include polyethylene terephthalate, polyethylene naphthalate, polycarbonate, polyimide, polyethylene sulfonate, polyarylate, hexamethyldisiloxane, an acrylic resin, or a combination thereof. The organic encapsulation layer 320 may provide a flat upper surface. Accordingly, even when an input sensing layer or the like is formed on the encapsulation layer 300 through a continuous process, a defect rate may be reduced.

The encapsulation layer 300 may entirely cover the display area DA and extend toward the peripheral area PA to cover at least a portion of the peripheral area PA. For example, the encapsulation layer 300 may extend to the valley area VA (refer to FIG. 2) of the peripheral area PA and directly contact the inorganic insulating layer IIL to form an inorganic contact area.

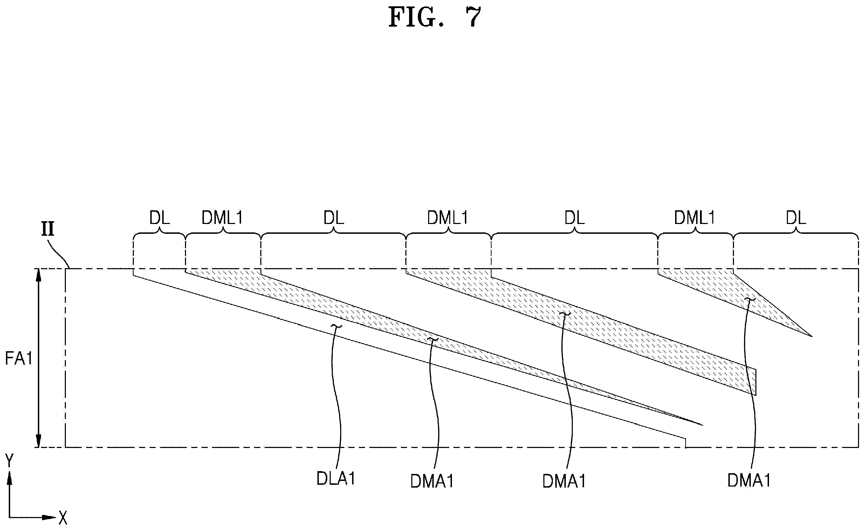

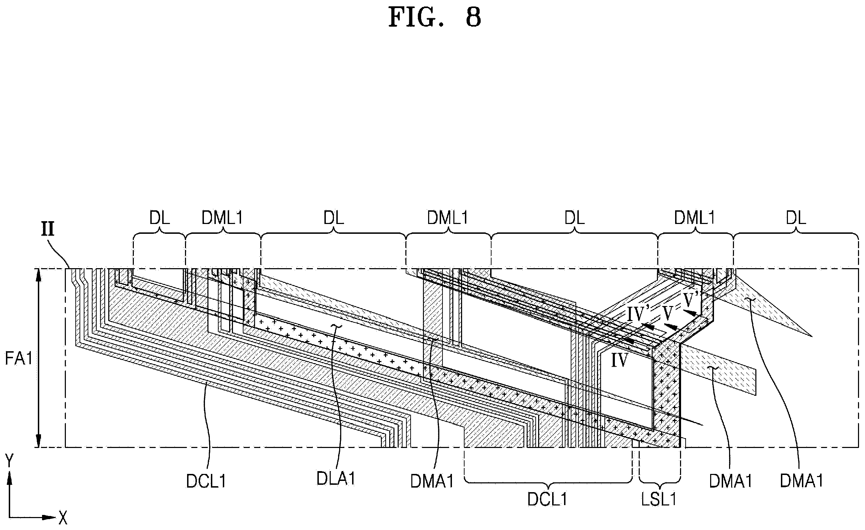

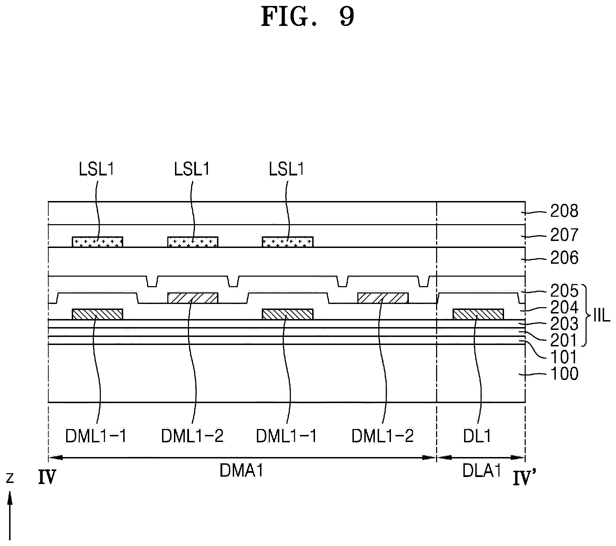

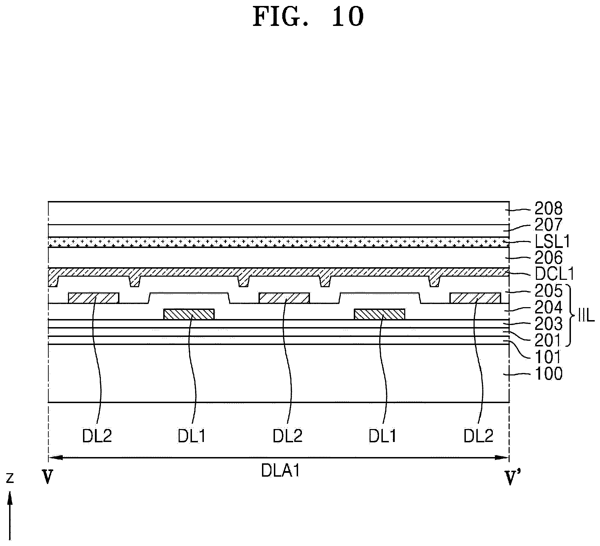

FIGS. 7 and 8 are plan views each schematically illustrating a portion of a display apparatus according to an embodiment, FIG. 9 is a cross-sectional view schematically illustrating a cross section of the display apparatus shown in FIG. 8, take along a line IV-IV', and FIG. 10 is a cross-sectional view schematically illustrating a cross section of the display apparatus shown in FIG. 8, taken along a line V-V'. FIGS. 7 and 8 may be plan views illustrating an enlarged region II of the display apparatus shown in FIG. 2.

For reference, for convenience of explanation, FIG. 7 shows only the data lines DL and first dummy lines DML1, and FIG. 8 shows the data lines DL, the first dummy lines DML1, first power lines DCL1, and the first sub-signal line LSL1.

Referring to FIG. 7, the first fan-out area FA1 may include a first line area DLA1 and a first dummy area DMA1 between first line areas DLA1.

The first line area DLA1 may be an area where the data lines DL are arranged, and the first dummy area DMA1 may be an area where the first dummy lines DML1 are arranged. The data lines DL may cross the first fan-out area FA1 to connect the first pad unit 10 (refer to FIG. 2) of the pad unit PAD (refer to FIG. 2) to the pixels PX (refer to FIG. 1) in the display area DA. In the disclosure, for convenience of explanation, each of lines is not individually shown, but the lines may be arranged to be spaced apart from each other within an area of a line area shown in the drawing. For example, for convenience of illustration, adjacent data lines DL are not individually shown, but the data lines DL may be arranged to be spaced apart from each other in the first line area DLA1. Similarly, in FIG. 7, the first dummy lines DML1 are not individually shown, the first dummy lines DML1 may be arranged to be spaced apart from each other in the first dummy area DMA1.

When viewed from a direction perpendicular to the substrate 100, the data lines DL are divided into a plurality of line groups by grouping adjacent lines from among the data lines DL. Ends of line groups (in the -y direction) adjacent to the pad unit PAD may be positioned adjacent to each other. Also, other ends of the line groups (in the +y direction) may be positioned to be relatively spaced apart from each other, as compared with the ends of the line groups (in the -y direction). Accordingly, when viewed from a direction perpendicular to the substrate 100, an area in which the data lines DL are not arranged may exist between branches of the line groups.

The first dummy lines DML1 may be arranged in an area between adjacent line groups. That is, the first dummy area DMA1 where the first dummy line DML1 is arranged may be an area between adjacent line groups. In this regard, FIG. 7 shows that the data lines DL include four line groups, and three first dummy areas DMA1 are arranged between adjacent line groups. However, the disclosure is not limited thereto, and the data lines DL may be divided into line groups having various types and numbers according to designs.

In an embodiment, when viewed from a direction perpendicular to the substrate 100, the first dummy lines DML1 may be patterned in the same or similar pattern as adjacent data lines DL. Accordingly, in an area where the data lines DL are not arranged, a difference in shading caused by overlapping of lines included in different layers may be reduced. The first dummy lines DML1 may be electrically insulated from the data line DL.

The first dummy lines DML1 may include the same material as a material of the data lines DL. In the disclosure, "A and B including the same material" may mean that A and B are formed through the same deposition process. Accordingly, A and B may have the same composition, membrane quality or layer structure. Also, it may mean that A and B are disposed on the same layer.

In an embodiment, as shown in FIGS. 9 and 10, the data lines DL may include first data lines DL1 between the first gate insulating layer 203 and the second gate insulating layer 204 and second data lines DL2 between the second gate insulating layer 204 and the interlayer insulating layer 205. When viewed from a direction perpendicular to the substrate 100, the first data lines DL1 and the second data lines DL2 may be spaced apart from each other and alternately arranged. Each of the first data lines DL1 and the second data lines DL2 may include a conductive material including Mo, Al, Cu, Ti, or the like, and may include a single layer or a multi-layer, each including the above material.

The first dummy lines DML1 may include first-1 dummy lines DML1-1 between the first gate insulating layer 203 and the second gate insulating layer 204 and first-2 dummy lines DML1-2 between the second gate insulating layer 204 and the interlayer insulating layer 205. When viewed from a direction perpendicular to the substrate 100, the first-1 dummy lines DML1-1 and the first-2 dummy lines DML1-2 may be spaced apart from each other and alternately arranged.

The first data lines DL1 may include the same material as the first-1 dummy lines DML1-1. The second data lines DL2 may include the same material as the first-2 dummy lines DML1-2.

Referring to FIG. 8, in the first fan-out area FA1, the data line DL, the first dummy line DML1, the first power lines DCL1, and the first sub-signal lines LSL1 may be arranged.

The first power lines DCL1 may be some of power lines for transferring the common voltage ELVSS (refer to FIG. 4), the first initialization voltage Vint (refer to FIG. 4), the second initialization voltage Vaint (refer to FIG. 4), or the like.

When view from a direction perpendicular to the substrate 100, the first power lines DCL1 may be arranged outside the first line area DLA1, and some of the first power lines DCL1 may cross the first fan-out area FA1 by overlapping the first line area DLA1 and the first dummy area DMA1.

As shown in FIG. 10, the first power lines DCL1 may be between the interlayer insulating layer 205 and the first planarization layer 206. The first power lines DCL1 may each include a conductive material including Mo, Al, Cu, Ti, or the like, and may include a multi-layer or a single layer, each including the above material. For example, the first power lines DCL1 may each include a multi-layered structure of Ti/Al/Ti. In an embodiment, the first power lines DCL1 may each include the same material as the source electrode SE (refer to FIG. 6) and the drain electrode DE (refer to FIG. 6) in the display area DA (refer to FIG. 6).

Referring to FIG. 8, when viewed from a direction perpendicular to the substrate 100, some of the first sub-signal lines LSL1 (in the -y direction), which are adjacent to the pad unit PAD (refer to FIG. 2), are positioned outside the first line area DLA1, but some of the first sub-signal lines LSL1 (in the +y direction) may overlap the first line area DLA1 and the first dummy area DMA1, and the first sub-signal lines LSL1 may cross the first fan-out area FA1.

As shown in FIGS. 9 and 10, the first sub-signal lines LSL1 may be between the first planarization layer 206 and the second planarization layer 207. The first sub-signal lines LSL1 may each include a conductive material including Mo, Al, Cu, Ti, or the like, and may include a single layer or a multi-layer, each including the above material. In an embodiment, the first sub-signal line LSL1 may include the same material as the first connection electrode CM1 (refer to FIG. 6) in the display area DA (refer to FIG. 6).

At least one layer of the organic insulating layer OIL (refer to FIG. 6) may be between the first sub-signal lines LSL1 and the data lines DL or the first dummy lines DML1. For example, the first planarization layer 206 may be between the first sub-signal lines LSL1 and the data lines DL or the first dummy lines DML1.

When viewed from a direction perpendicular to the substrate 100, as shown in FIG. 8, some of the first sub-signal lines LSL1, which are arranged in an area overlapping the data lines DL, may extend in a direction crossing the data lines DL.

On the contrary, when viewed from a direction perpendicular to the substrate 100, some other first sub-signal lines LSL1, which are arranged in an area overlapping the first dummy lines DML1, may extend in a direction parallel to the first dummy lines DML1. In an embodiment, when viewed from a direction perpendicular to the substrate 100, some of the first sub-signal lines LSL1, which are arranged in an area overlapping the first dummy lines DML1, may have the same pattern as the first dummy line DML1.

In the first dummy area DMA1 in which the first sub-signal lines LSL1 overlap the first dummy lines DML1, the first power line DCL1 may or may not be disposed below the first sub-signal line LSL1. However, in the first line area DLA1 where the first sub-signal line LSL1 overlap the data lines DL, the first power line DCL1 may be between the first sub-signal line LSL1 and the data lines DL, so that electrical interference, such as coupling capacitance between the first sub-signal line LSL1 and the data line DL, may be minimized. That is, as shown in FIG. 10, in an area where the first sub-signal lines LSL1 overlap the data lines DL, the first power line DCL1 may cover the data lines DL to shield between the first sub-signal line LSL1 and the data line DL.

As shown in FIG. 2, the substrate 100 may have the bending area BA (refer to FIG. 2) for bending the substrate 100 so that a portion of the peripheral area PA (refer to FIG> 2) overlaps the display area DA. The bending area BA (refer to FIG. 2) may overlap the first fan-out area FA1. Accordingly, the first sub-signal line LSL1 may cross the bending area BA (refer to FIG. 2).

As shown in FIG. 10, the second planarization layer 207 and the third planarization layer 208 may be sequentially stacked on the first sub-signal line LSL1 in a thickness direction (a z axis direction) of the display apparatus 1 (refer to FIG. 1).

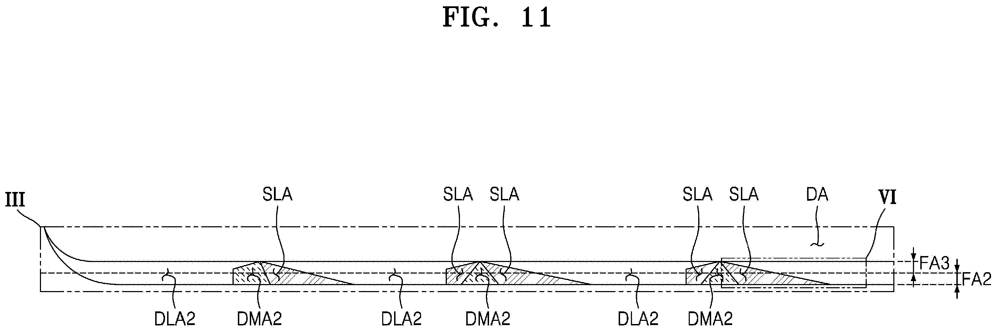

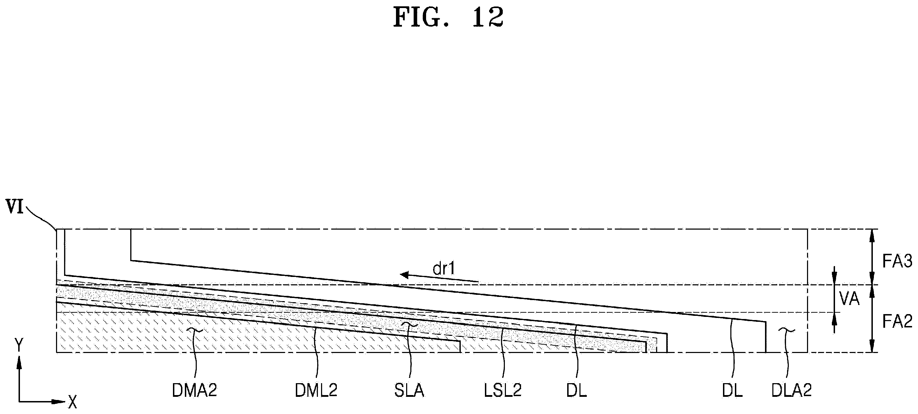

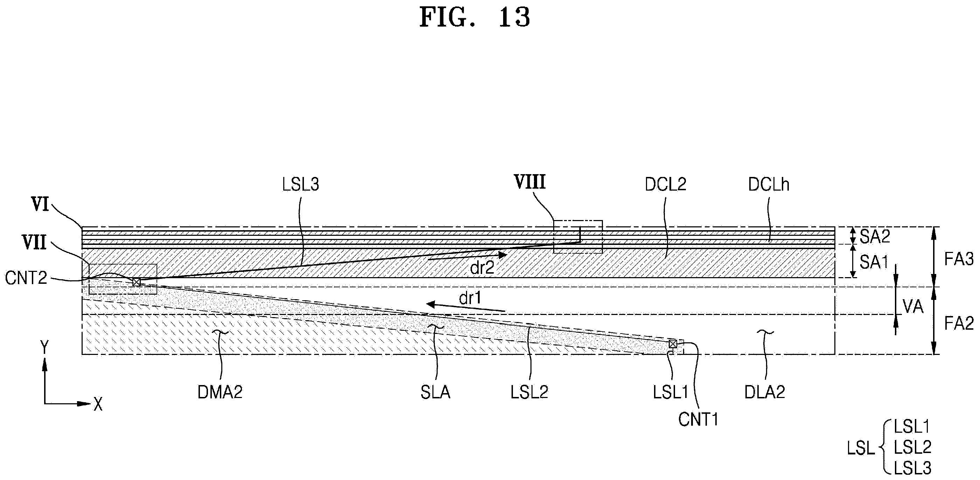

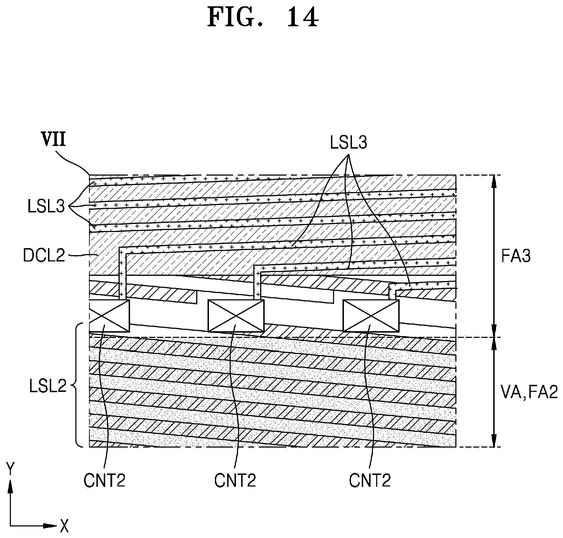

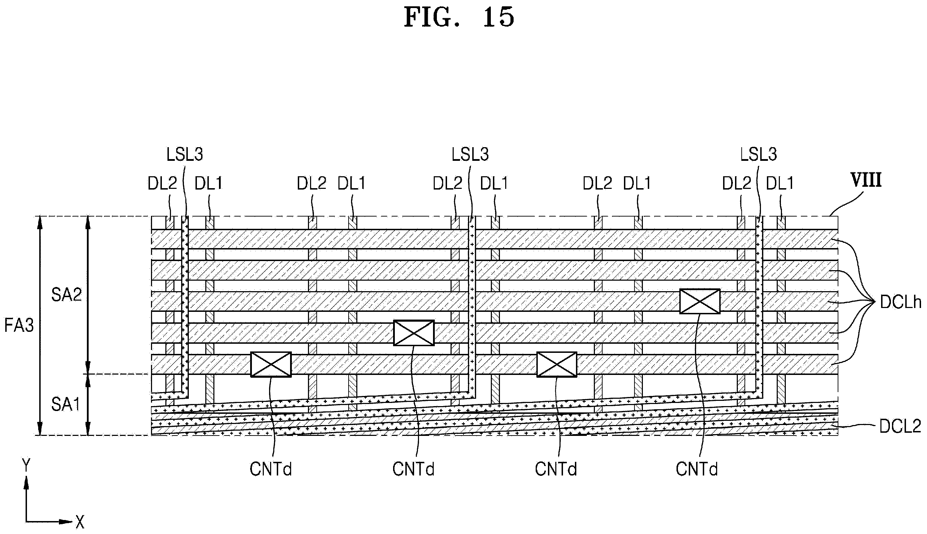

FIGS. 11 to 15 are plan views each schematically illustrating a portion of a display apparatus according to an embodiment. FIG. 11 is a plan view schematically illustrating an enlarged region III of the display apparatus shown in FIG. 2. FIGS. 12 and 13 are plan views each schematically illustrating an enlarged region VI of the display apparatus shown in FIG. 11. FIG. 14 is an enlarged plan view illustrating an enlarged region VII of the display apparatus shown in FIG. 13, and FIG. 15 is an enlarged plan view illustrating an enlarged region VIII of the display apparatus of FIG. 13.

Referring to FIGS. 11 to 13, the substrate 100 (refer to FIG. 2) may include the third fan-out area FA3 in contact with the boundary of the display area DA and the second fan-out area FA2 between the third fan-out area FA3 and the first fan-out area FA1 (refer to FIG. 2).

When viewed from a direction perpendicular to the substrate 100, the second fan-out area FA2 may overlap the valley area VA from which a portion of the organic insulating layer OIL (refer to FIG. 6) is removed. That is, the second fan-out area FA2 may be defined as an area from an upper boundary of the first fan-out area FA1 (in the +y direction) and an upper boundary of the valley area VA (in the +y direction).

The second fan-out area FA2 and the third fan-out area FA3 may each include a second line area DLA2, a second dummy area DMA2, and a light sensing signal line area SLA. The second line area DLA2 may be an area where the data lines DL are arranged, the second dummy area DMA2 may be an area where second dummy lines DML2 are arranged, and the light sensing signal line area SLA may be an area where the second sub-signal line LSL2 is arranged.

The data lines DL may extend from the first line area DLA1 (refer to FIG. 7) of the first fan-out area FA1 to the third fan-out area FA3 via the second line area DLA2 of the second fan-out area FA2. The data lines DL, which were divided into a plurality of line groups in the first fan-out area FA1, may be combined into one group again in the third fan-out area FA3 by passing through the second fan-out area FA2. Accordingly, when viewed from a direction perpendicular to the substrate 100, an area in which the data lines DL are not arranged may exist between branches of the line groups.

The second sub-signal line LSL2 may be arranged in an area between adjacent line groups. That is, the light sensing signal line area SLA where the second sub-signal lines LSL2 are arranged may be an area between adjacent line groups. The second dummy lines DML2 may be arranged in an area between the second sub-signal lines LSL2 and an area between the second sub-signal line LSL2 and the data line DL. The second dummy area DMA2 where the second dummy lines DML2 are arranged may be an area between the second sub-signal lines LSL2 and an area between the second sub-signal line LSL2 and the data line DL.

FIG. 12 shows the second dummy line DML2 arranged in the second dummy area DMA2, the second sub-signal line LSL2 arranged in the light sensing signal line area SLA, and the data lines DL arranged in the second line area DLA2.

When viewed from a direction perpendicular to the substrate 100, the second sub-signal lines LSL2 may be patterned in the same or similar pattern as the data lines DL adjacent thereto. Similarly, the second dummy lines DML2 may be patterned in the same or similar pattern as the data lines DL or the second sub-signal lines LSL2 adjacent thereto.

The second sub-signal lines LSL2 may include the same material as the data lines DL. For example, the second sub-signal lines LSL2 may include second-1 sub-signal lines (not shown) between the first gate insulating layer 203 (refer to FIG. 10) and the second gate insulating layer 204 (refer to FIG. 10), and second-2 sub-signal lines (not shown) between the second gate insulating layer 204 (refer to FIG. 10) and the interlayer insulating layer 205 (refer to FIG. 10). As shown in FIG. 14, the second-1 sub-signal lines and the second-2 sub-signal lines may be alternately arranged. That is, the second sub-signal lines LSL2 may be disposed below the interlayer insulating layer 205 (refer to FIG. 10) covering the data lines DL.

The second dummy lines DML2 may include the same material as the data lines DL. For example, the second dummy lines DML2 may include second-1 dummy lines (not shown) between the first gate insulating layer 203 (refer to FIG. 10) and the second gate insulating layer 204 (refer to FIG. 10), and second-2 dummy lines (not shown) between the second gate insulating layer 204 (refer to FIG. 10) and the interlayer insulating layer 205 (refer to FIG. 10).

The first data lines DL1 (refer to FIG. 10), the second-1 sub-signals, and the second-1 dummy lines may include the same material. The second data lines DL2 (refer to FIG. 10), the second-2 sub-signal lines, and the second-2 dummy lines may include the same material.

The second dummy lines DML2 may be spaced apart from the data lines DL and the second sub-signal lines LSL2 and may be electrically insulated therefrom.

The second sub-signal lines LSL2 extend from the first sub-signal lines LSL1 to the third sub-signal line LSL3, and each of which is connected to the first sub-signal line LSL1 and the third sub-signal line LSL3 on a one-to one basis. The second sub-signal lines LSL2 may be terminated at the upper boundary of the second fan-out area FA2 (in the +y direction).

The second fan-out area FA2 may include the valley area VA extending in a direction (an x-axis direction) parallel to a boundary of the display area DA. The valley area VA may be an area overlapping an opening formed by removing a portion of the organic insulating layer OIL (refer to FIG. 6) extending from the display area DA and the peripheral area PA. In the valley area VA, an inorganic encapsulation layer of the encapsulation layer 300 (refer to FIG. 6) may be in direct contact with the inorganic insulating layer IIL to reduce or prevent impurities such as moisture or the like from penetrating into the display area DA.

Because the first planarization layer 206 (refer to FIG. 10) that separates the first sub-signal line LSL1 and the data lines DL from each other in the thickness direction (the z-axis direction) of a display apparatus 1 (refer to FIG. 1) has an opening overlapping the valley area VA, the first sub-signal line LSL1 and the third sub-signal line LSL3 may be electrically connected to each other through the second sub-signal line LSL2 crossing the valley area VA. Because the second sub-signal line LSL2 is disposed on the same layer as the data lines DL, electrical interference between the second sub-signal line LSL2 and the data lines DL may also be reduced or minimized by ensuring a sufficient distance between the second sub-signal line LSL2 and the data lines DL in a horizontal direction. Also, the second sub-signal line LSL2 may have the same or similar pattern as the data lines DL and the second dummy lines DML2 and include the same material as the data lines DL and the second dummy lines DML2, the second sub-signal line LSL2 may be formed without an additional mask process.

As shown in FIG. 13, the third fan-out area FA3 may include a first sub area SA1 where a second power line DCL2 is arranged and a second sub area SA2 where a horizontal power line DCLh is arranged.

The second power lines DCL2 may be some of power lines for transferring the common voltage ELVSS (refer to FIG. 4), the first initialization voltage Vint (refer to FIG. 4), the second initialization voltage Vaint (refer to FIG. 4), or the like.

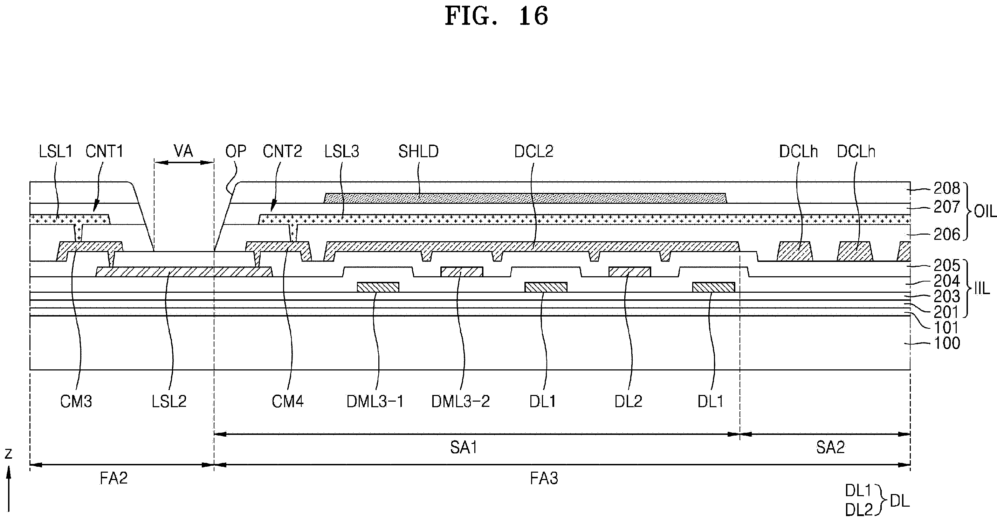

When viewed from a direction perpendicular to the substrate 100, in the first sub area SA1, the second power lines DCL2 may be arranged to overlap the data lines DL (refer to FIG. 12) and the third sub-signal line LSL3. The second power lines DCL2 may be between the interlayer insulating layer 205 (refer to FIG. 16) and the first planarization layer 206 (refer to FIG. 16). In an embodiment, the second power lines DCL2 may include the same material as the source electrode SE and the drain electrode DE in the display area DA (refer to FIG. 6). The second power lines DCL2 may be between the data line DL and the third sub-signal lines LSL3, so that electrical interference, such as coupling capacitance between the third sub-signal lines LSL3 and the data line DL, may be minimized.

When viewed from a direction perpendicular to the substrate 100, in the second sub area SA2, the horizontal power lines DCLh may extend in a direction (the x axis direction) parallel to the fourth edge E4 (refer to FIG. 1) of the display area DA. The horizontal power lines DCLh may be orthogonally cross the data lines DL and the third sub-signal lines LSL3. That is, in the second sub area SA2, the data lines DL and the third sub-signal lines LSL3 may extend in a direction (a y axis direction) orthogonal to the fourth edge E4 (refer to FIG. 1) of the display area DA to be connected to the pixel PX (refer to FIG. 1) and the light sensor LS (refer to FIG. 1) in the display area DA.

The horizontal power lines DCLh may be between the interlayer insulating layer 205 (refer to FIG. 16) and the first planarization layer 206 (refer to FIG. 16). In an embodiment, the horizontal power lines DCLh may include the same material as the source electrode SE and the drain electrode DE in the display area DA (refer to FIG. 6). The horizontal power lines DCLh may be some of power lines having a mesh shape, which are configured to transfer the common voltage ELVSS (refer to FIG. 4), the first initialization voltage Vint (refer to FIG. 4), the second initialization voltage Vaint (refer to FIG. 4), or the like to each pixel PX (refer to FIG. 1).

The third sub-signal lines LSL3 may be arranged in the third fan-out area FA3. When viewed from a direction perpendicular to the substrate 100, the third sub-signal lines LSL3 may extend to cross the first sub area SA1. As described above, in the second sub area SA2, the third sub-signal lines LSL3 may extend in a direction (the y axis direction) orthogonal to the fourth boundary E4 (refer to FIG. 1) of the display area DA by changing an extension direction. In other words, ends of the third sub-signal lines LSL3 (in the -y direction) adjacent to the second fan-out area FA2 may be positioned adjacent to each other. Other ends of the third sub-signal lines LSL3 (in the +y direction) adjacent to the display area DA may be positioned to relatively spaced apart from each other, as compared to the ends of the third sub-signal lines LSL3 (in the -y direction).

At least one layer of the organic insulating layer OIL may be between the third sub-signal lines LSL3 and the data lines DL. For example, the first planarization layer 206 may be between the third sub-signal lines LSL3 and the data lines DL.

As described above, the first sub-signal line LSL1, the second sub-signal line LSL2, and the third sub-signal line LSL3 are electrically connected to each other to function as the light sensing signal line LSL.

The first sub-signal line LSL1 may be arranged in the first fan-out area FA1, and one end thereof crossing the first fan-out area FA1 (in the +y direction) may be arranged adjacent to a lower boundary of the second fan-out area FA2 (in the -y direction). An end of the first sub-signal line LSL1 (in the +y direction) and an end of the second sub-signal line LSL2 (in the -y direction) may be electrically connected to each other through a first contact portion CNT1.

The second sub-signal line LSL2 may be arranged in the second fan-out area FA2, and another end thereof crossing the second fan-out area FA2 (in the +y direction) may be arranged adjacent to a lower boundary (or an upper boundary of the valley area VA) of the third fan-out area FA3 (in the -y direction). The other end of the second sub-signal line LSL2 (in the +y direction) and an end of the third sub-signal line LSL3 (in the -y direction) may be electrically connected to each other through a second contact portion CNT2. FIG. 14 is an enlarged view of an area adjacent to the second contact portion CNT2 where the second sub-signal line LSL2 and the third sub-signal line LSL3 are connected to each other.

The second power line DCL2 and the third sub-signal lines LSL3 may be arranged in the third fan-out area FA3. The second power line DCL2 may be disposed on the interlayer insulating layer 205 (refer to FIG. 16), and the third sub-signal line LSL3 may be disposed on the first planarization layer 206 (refer to FIG. 16).

As described above, because the second sub-signal lines LSL2 have the same or similar pattern as the data line DL and the second dummy line DML2, the second sub-signal lines LSL2 may extend in a first direction dr1 parallel to a direction of the data lines DL (refer to FIG. 12). On the contrary, the third sub-signal lines LSL3 may extend in a second direction dr2 crossing the data lines DL (refer to Figs. 12 and 13) to be spaced apart from each other at a uniform interval corresponding to the position of the pixel PX (refer to FIG. 1) at the fourth edge E4 (refer to FIG. 1) of the display area DA.

The third sub-signal lines LSL3 may extend in a second direction dr2 (refer to FIG. 13) oblique to the fourth edge E4 (refer to FIG. 1) of the display area DA in the first sub area SA1, and then extend in a direction (the y axis direction) orthogonal to the fourth edge E4 (refer to FIG. 1) of the display area DA in the second sub area SA2. FIG. 15 is an enlarged view of an area adjacent to a boundary between the first sub area SA1 and the second sub area SA2.

When viewed from a direction perpendicular to the substrate 100, in the second sub area SA2, the third sub-signal lines LSL3 may be arranged in a direction parallel to the first data lines DL1 and the second data lines DL2. As described above, the horizontal power lines DCLh may be some of power lines having a mesh shape. Accordingly, power contact portions CNTd for connecting vertical power lines (not shown) extending in a direction (the y axis direction) orthogonal to the fourth edge E4 (refer to FIG. 1) of the display area DA and the horizontal power lines DCLh to each other may be arranged in the second line area DLA2. The third sub-signal line LSL3 may extend in a direction (the y axis direction) orthogonal to the horizontal power lines DCLh to avoid overlapping the power contact portions CNTd.

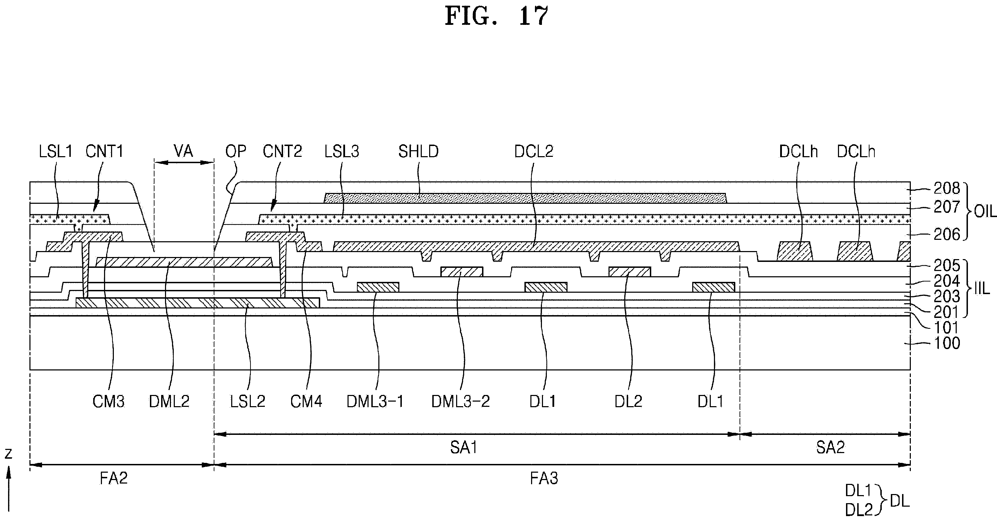

FIG. 16 is a cross-sectional view schematically illustrating a portion of a display apparatus according to an embodiment, and FIG. 17 is a cross-sectional view schematically illustrating a portion of a display apparatus according to another embodiment. For reference, FIGS. 16 and 17 show a cross section of a display apparatus taken along a center line of the first sub-signal line LSL1, the second sub-signal line LSL2, and the third sub-signal line LSL3 in the second fan-out area FA2 and the third fan-out area FA3.

Referring to FIG. 16, the inorganic insulating layer IIL may be disposed on the substrate 100. The inorganic insulating layer IIL may include the buffer layer 201, the first gate insulating layer 203, the second gate insulating layer 204, and the interlayer insulating layer 205, which are sequentially stacked in the thickness direction (the z axis direction) of the display apparatus 1 (refer to FIG. 1).

The organic insulating layer OIL may be disposed on the inorganic insulating layer IIL. The organic insulating layer OIL may include the first planarization layer 206, the second planarization layer 207, and the third planarization layer 208, which are sequentially stacked in the thickness direction (the z axis direction) of the display apparatus.

The second fan-out area FA2 may include the valley area VA formed by removing a portion of the organic insulating layer OIL. Each of the first planarization layer 206, the second planarization layer 207, and the third planarization layer 208 may have an opening portion OP overlapping the valley area VA. In the valley area VA, an inorganic encapsulation layer of the encapsulation layer 300 (refer to FIG. 6) may be in direct contact with the inorganic insulating layer IIL to form an inorganic contact area.

Ends of the first sub-signal lines LSL1 may be arranged in the second fan-out area FA2. The first sub-signal lines LSL1 may be between the first planarization layer 206 and the second planarization layer 207. The first sub-signal lines LSL1 may include the same material as the first connection electrode CM1 (refer to FIG. 6) in the display area DA (refer to FIG. 2).

The first sub-signal lines LSL1 may be electrically connected to the second sub-signal line LSL2 through the first contact portion CNT1. The first contact portion CNT1 may include a third connection electrode CM3 between the interlayer insulating layer 205 and the first planarization layer 206.

The second sub-signal lines LSL2 may be between the second gate insulating layer 204 and the interlayer insulating layer 205. In this case, the second sub-signal lines LSL2 may include the same material as third-2 dummy lines DML3-2 and the second data lines DL2.

In another embodiment, the second sub-signal lines LSL2 may be between the first gate insulating layer 203 and the second gate insulating layer 204. For example, the second sub-signal lines LSL2 may include the same material as third-1 dummy lines DML3-1 and the first data lines DL1.

The third fan-out area FA3 may include the first sub area SA1 where the second power line DCL2 is arranged and the second sub area SA2 wherein the horizontal power line DCLh is arranged.

In the third fan-out area FA3, the third sub-signal lines LSL3 may be between the first planarization layer 206 and the second planarization layer 207. The third sub-signal lines LSL3 may include the same material as the first connection electrode CM1 (refer to FIG. 6) in the display area DA (refer to FIG. 2). The third sub-signal lines LSL3 may extend to the display area DA (refer to FIG. 2) by passing through the first sub area SA1 and the second sub area SA2.

Ends of the second sub-signal lines LSL2 may be arranged in the third fan-out area FA3. The second sub-signal lines LSL2 may be electrically connected to the third sub-signal line LSL3 through the second contact portion CNT2. The second contact portion CNT2 may include a fourth connection electrode CM4 between the interlayer insulating layer 205 and the first planarization layer 206.

The second power line DCL2 may be between the third sub-signal line LSL3 and the first data line DL1 and second data line DL2. The second power line DCL2 may be between the interlayer insulating layer 205 and the first planarization layer 206. The second power line DCL2 may include the same material as the source electrode SE and the drain electrode DE in the display area DA (refer to FIG. 2). The second power lines DCL2 may be some of power lines for transferring the common voltage ELVSS (refer to FIG. 4), the first initialization voltage Vint (refer to FIG. 4), the second initialization voltage Vaint (refer to FIG. 4), or the like.

The second power lines DCL2 may be between the data line DL and the third sub-signal lines LSL3, so that electrical interference, such as coupling capacitance between the third sub-signal lines LSL3 and the data line DL, may be minimized.

To secure a sufficient horizontal separation distance between the second sub-signal lines LSL2 and the first data lines DL1 and second data lines DL2, the third-1 dummy lines DML3-1 and the third-2 dummy lines DML3-2 may be between the second sub-signal lines LSL2 and the first data lines DL1 and second data lines DL2. The third-1 dummy lines DML3-1 and the third-2 dummy lines DML3-2 may be arranged at a boundary portion of the light sensing signal line area SLA and the second line area DLA2 shown in FIG. 12.

A shielding layer SHLD may be arranged in the first sub area SA1. The shielding layer SHLD may be between the second planarization layer 207 and the third planarization layer 208. The shielding layer SHLD may include the same material as the second connection electrode CM2 in the display area DA (refer to FIG. 2). The shielding layer SHLD may be electrically connected to the second power line DCL2.

When viewed from a direction perpendicular to the substrate 100, the shielding layer SHLD may be arranged to overlap the third sub-signal line LSL3. Although not illustrated in FIGS. 16 and 17, an input sensing signal line (not shown) configured to transfer a touch input signal may be disposed on the third planarization layer 208. The shielding layer SHLD may be between the third sub-signal line LSL3 and the input sensing signal line to minimize electrical interference, such as coupling capacitance between the third sub-signal line LSL3 and the input sensing signal line.

The horizontal power lines DCLh may be between the interlayer insulating layer 205 and the first planarization layer 206. The horizontal power lines DCLh may include the same material as the source electrode SE and the drain electrode DE in the display area DA (refer to FIG. 2). The horizontal power lines DCLh may be some of power lines having a mesh shape, which are configured to transfer the common voltage ELVSS (refer to FIG. 4), the first initialization voltage Vint (refer to FIG. 4), the second initialization voltage Vaint (refer to FIG. 4), or the like to each pixel PX (refer to FIG. 1). The horizontal power lines DCLh may extend in a direction orthogonal to the third sub-signal line LSL3 to avoid the third sub-signal lines LSL3 from overlapping the power contact portions CNTd (refer to FIG. 15) connecting the horizontal power lines DCLh and the vertical power lines (not shown).

FIG. 17 is similar to FIG. 16, but differs in that the second sub-signal line LSL2 is between the barrier layer 101 and the buffer layer 201. Hereinafter, descriptions of the same or similar components given above are omitted, differences are mainly described.

Referring to FIG. 17, the second sub-signal line LSL2 may be between the barrier layer 101 and the buffer layer 201. The second sub-signal line LSL2 may include a conductive material including Mo, Al, Cu, Ti, or the like, and may include a single layer or a multi-layer, each including the above material. However, the disclosure is not limited thereto, and the second sub-signal lines LSL2 may be disposed between layers of the inorganic insulating layer IIL or below the inorganic insulating layer IIL. Accordingly, in the valley area VA, connection with other lines on the interlayer insulating layer 205 may be prevented.

When viewed from a direction perpendicular to the substrate 100, the second sub-signal lines LSL2 may be arranged adjacent to the second dummy lines DML2. When viewed from a direction perpendicular to the substrate 100, the second sub-signal lines LSL2 may extend in a direction parallel to the second dummy lines DML2. At this time, as the second sub-signal lines LSL2 are patterned in the same or similar pattern as the second dummy lines DML2, a sufficient separation distance between the first data lines DL1 and the second data lines DL2 may be secured.

Also, in another embodiment, the third sub-signal line LSL3 may be between the second planarization layer 207 and the third planarization layer 208. In this case, the shielding layer SHLD may be disposed on the third planarization layer 208, and a fourth planarization layer for covering the shielding layer SHLD may be further provided.

According to the embodiment described above, a display apparatus displaying high-quality images by reducing electrical interference between lines may be implemented. For example, electrical interference between signal and data lines may be reduced or minimized by ensuring a sufficient distance between those lines in a horizontal direction. The scope of the disclosure is not limited by these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present invention as defined by the appended claims.

## Claims

1. A display apparatus (1) comprising:
a substrate (100) comprising a display area (DA) in which a light-emitting diode (ED) and a light sensor (LS) is arranged and a peripheral area (PA) outside the display area (DA);
data lines (DL) in the peripheral area (PA); and
light sensing signal lines (LSL) comprising a first sub-signal line (LSL1) in the peripheral area (PA), a third sub-signal line (LSL3) spaced apart from the first sub-signal line (LSL1) and positioned closer to the display area (DA) than the first sub-signal line (LSL1), and a second sub-signal line (LSL2) connecting the first sub-signal line (LSL1) to the third sub-signal line (LSL3),
wherein, when viewed from a direction perpendicular to the substrate (100), the data lines (DL) are divided into a plurality of line groups, and the second sub-signal line (LSL2) is between the plurality of line groups,
**characterized in that**
the second sub-signal line (LSL2) is disposed in a different layer from the first sub-signal line (LSL1) and the third sub-signal line (LSL3).

2. The display apparatus (1) of claim 1, further comprising:
an interlayer insulating layer (205) disposed on the data lines (DL) to cover the data lines (DL);
first power lines (DCL1) disposed on the interlayer insulating layer (205); and
a first planarization layer (206) arranged between the first power lines (DCL1) and the first sub-signal line (LSL1) to cover the first power lines (DCL1).

3. The display apparatus (1) of claim 2, wherein the first power lines (DCL1) are between the first sub-signal line (LSL1) and the data lines (DL) in an area in which the first sub-signal line (LSL1) overlap the data lines (DL).

4. The display apparatus (1) of any one of the preceding claims, wherein the substrate (100) comprises a bending area (BA) to bend the substrate (100) so that a portion of the peripheral area (PA) overlaps the display area (DA), and
the first sub-signal line (LSL1) crosses the bending area (BA).

5. The display apparatus (1) of claim 1, further comprising a first planarization layer (206) disposed on the data lines (DL),
wherein, when viewed from a direction perpendicular to the substrate (100), the substrate (100) comprises a valley area (VA) extending in a first direction parallel to a boundary of the display area (DA), and the first planarization layer (206) has an opening overlapping the valley area (VA).

6. The display apparatus (1) of claim 5,
wherein, when viewed from a direction perpendicular to the substrate (100), the second sub-signal line (LSL2) crosses the valley area (VA); and/or
wherein the second sub-signal line (LSL2) is disposed below the first planarization layer (206); and/or
wherein the second sub-signal line (LSL2) comprises a same material as each of the data lines (DL).

7. The display apparatus (1) of claim 5 or 6, further comprising an inorganic insulating layer (201) below the data lines (DL),
wherein the second sub-signal line (LSL2) is between the inorganic insulating layer (201) and the substrate (100).

8. The display apparatus (1) of claim 1, further comprising an interlayer insulating layer (205) disposed on the data lines (DL) to cover the data lines (DL);
second power lines (DCL2) disposed on the interlayer insulating layer (205); and
a first planarization layer (206) between the second power lines (DCL2) and the third sub-signal line (LSL3) to cover the second power lines (DCL2).

9. The display apparatus (1) of claim 8, wherein the second power lines (DCL2) are between the third sub-signal line (LSL3) and the data lines (DL) in an area in which the third sub-signal line (LSL3) overlap the data lines (DL).

10. The display apparatus (1) of claim 8 or 9, further comprising horizontal power lines (DCLh) arranged between the interlayer insulating layer (205) and the first planarization layer (206) and positioned closer to the display area (DA) than the second power lines (DCL2),
wherein the horizontal power lines (DCLh) extend in a first direction parallel to a boundary of the display area (DA), when viewed in a direction perpendicular to the substrate (100).

11. The display apparatus (1) of claim 10, wherein the third sub-signal line (LSL3) extends in a second direction perpendicular to the first direction in an area overlapping the horizontal power lines (DCLh).

12. The display apparatus (1) of any one of claims 8 to 11, further comprising:
a second planarization layer (207) disposed on the third sub-signal line (LSL3) to cover the third sub-signal line (LSL3); and
a shielding layer (SHLD) disposed on the second planarization layer (207).

13. The display apparatus (1) of claim 12,
wherein the shielding layer (SHLD) is electrically connected to the second power lines (DCL2); and/or
wherein the shielding layer (SHLD) overlaps the third sub-signal line (LSL3), when viewed from a direction perpendicular to the substrate (100).

14. The display apparatus (1) of any one of the preceding claims, further comprising dummy lines (DML) arranged between the plurality of line groups and comprising a same material as each of the data lines (DL).

15. The display apparatus (1) of claim 14,
wherein a portion of the first sub-signal line (LSL1), the portion overlapping the dummy lines (DML), extends in a direction parallel to the dummy lines (DML), and another portion of the first sub-signal line (LSL1), the other portion overlapping the data lines (DL), extends in a direction crossing the data lines (DL); and/or
wherein the dummy lines (DML) are between the second sub-signal line (LSL2) and the data lines (DL), when viewed from a direction perpendicular to the substrate (100); and/or
wherein, when viewed from a direction perpendicular to the substrate (100), the second sub-signal line (LSL2) overlaps the dummy lines (DML), and the second sub-signal line (LSL2) extends in a direction parallel to the dummy lines (DML).

## Patentansprüche

1. Anzeigevorrichtung (1), die Folgendes umfasst:
ein Substrat (100), das einen Anzeigebereich (DA), in dem eine Leuchtdiode (ED) und ein Lichtsensor (LS) angeordnet sind, sowie einen Peripheriebereich (PA) außerhalb des Anzeigebereichs (DA) umfasst;
Datenleitungen (DL) im Peripheriebereich (PA); und
Lichterfassungs-Signalleitungen (LSL), umfassend eine erste Teilsignalleitung (LSL1) im Peripheriebereich (PA), eine dritte Teilsignalleitung (LSL3), die von der ersten Teilsignalleitung (LSL1) beabstandet ist und näher am Anzeigebereich (DA) liegt als die erste Teilsignalleitung (LSL1), und eine zweite Teilsignalleitung (LSL2), die die erste Teilsignalleitung (LSL1) mit der dritten Teilsignalleitung (LSL3) verbindet,
wobei, aus einer Richtung senkrecht zum Substrat (100) betrachtet, die Datenleitungen (DL) in mehrere Leitungsgruppen unterteilt sind, und wobei sich die zweite Teilsignalleitung (LSL2) zwischen den mehreren Leitungsgruppen befindet,
**dadurch gekennzeichnet, dass**
die zweite Teilsignalleitung (LSL2) in einer anderen Schicht als die erste Teilsignalleitung (LSL1) und die dritte Teilsignalleitung (LSL3) angeordnet ist.

2. Anzeigevorrichtung (1) nach Anspruch 1, die ferner Folgendes umfasst:
eine isolierende Zwischenschicht (205), die auf den Datenleitungen (DL) angeordnet ist, um die Datenleitungen (DL) abzudecken;
erste Stromleitungen (DCL1), die auf der isolierenden Zwischenschicht (205) angeordnet sind; und
eine erste Planarisierungsschicht (206), die zwischen den ersten Stromleitungen (DCL1) und der ersten Teilsignalleitung (LSL1) angeordnet ist, um die ersten Stromleitungen (DCL1) abzudecken.

3. Anzeigevorrichtung (1) nach Anspruch 2, wobei sich die ersten Stromleitungen (DCL1) zwischen der ersten Teilsignalleitung (LSL1) und den Datenleitungen (DL) in einem Bereich befinden, in dem sich die erste Teilsignalleitung (LSL1) mit den Datenleitungen (DL) überlappt.

4. Anzeigevorrichtung (1) nach einem der vorstehenden Ansprüche, wobei das Substrat (100) einen Biegebereich (BA) umfasst, um das Substrat (100) so zu biegen, dass sich ein Abschnitt des Peripheriebereichs (PA) mit dem Anzeigebereich (DA) überlappt, und
wobei die erste Teilsignalleitung (LSL1) den Biegebereich (BA) kreuzt.

5. Anzeigevorrichtung (1) nach Anspruch 1, die ferner eine erste Planarisierungsschicht (206) umfasst, die auf den Datenleitungen (DL) angeordnet ist,
wobei, aus einer Richtung senkrecht zum Substrat (100) betrachtet, das Substrat (100) einen Talbereich (VA) umfasst, der sich in einer ersten Richtung parallel zu einer Grenze des Anzeigebereichs (DA) erstreckt, und wobei die erste Planarisierungsschicht (206) eine Öffnung aufweist, die sich mit dem Talbereich (VA) überlappt.

6. Anzeigevorrichtung (1) nach Anspruch 5,
wobei, aus einer Richtung senkrecht zum Substrat (100) betrachtet, die zweite Teilsignalleitung (LSL2) den Talbereich (VA) kreuzt; und/oder
wobei die zweite Teilsignalleitung (LSL2) unterhalb der ersten Planarisierungsschicht (206) angeordnet ist; und/oder
wobei die zweite Teilsignalleitung (LSL2) aus dem gleichen Material wie jede der Datenleitungen (DL) besteht.

7. Anzeigevorrichtung (1) nach Anspruch 5 oder 6, die ferner eine anorganische Isolierschicht (201) unterhalb der Datenleitungen (DL) umfasst,
wobei sich die zweite Teilsignalleitung (LSL2) zwischen der anorganischen Isolierschicht (201) und dem Substrat (100) befindet.

8. Anzeigevorrichtung (1) nach Anspruch 1, die ferner Folgendes umfasst: eine isolierende Zwischenschicht (205), die auf den Datenleitungen (DL) angeordnet ist, um die Datenleitungen (DL) abzudecken;
zweite Stromleitungen (DCL2), die auf der isolierenden Zwischenschicht (205) angeordnet sind; und
eine erste Planarisierungsschicht (206) zwischen den zweiten Stromleitungen (DCL2) und der dritten Teilsignalleitung (LSL3), um die zweiten Stromleitungen (DCL2) abzudecken.

9. Anzeigevorrichtung (1) nach Anspruch 8, wobei sich die zweiten Stromleitungen (DCL2) zwischen der dritten Teilsignalleitung (LSL3) und den Datenleitungen (DL) in einem Bereich befinden, in dem sich die dritte Teilsignalleitung (LSL3) mit den Datenleitungen (DL) überlappt.

10. Anzeigevorrichtung (1) nach Anspruch 8 oder 9, die ferner horizontale Stromleitungen (DCLh) umfasst, die zwischen der isolierenden Zwischenschicht (205) und der ersten Planarisierungsschicht (206) angeordnet sind und näher am Anzeigebereich (DA) liegen als die zweiten Stromleitungen (DCL2),
wobei sich die horizontalen Stromleitungen (DCLh), aus einer Richtung senkrecht zum Substrat (100) betrachtet, in einer ersten Richtung parallel zu einer Grenze des Anzeigebereichs (DA) erstrecken.

11. Anzeigevorrichtung (1) nach Anspruch 10, wobei sich die dritte Teilsignalleitung (LSL3) in einer zweiten Richtung senkrecht zur ersten Richtung in einem Bereich erstreckt, der sich mit den horizontalen Stromleitungen (DCLh) überlappt.

12. Anzeigevorrichtung (1) nach einem der Ansprüche 8 bis 11, die ferner Folgendes umfasst:
eine zweite Planarisierungsschicht (207), die auf der dritten Teilsignalleitung (LSL3) angeordnet ist, um die dritte Teilsignalleitung (LSL3) abzudecken; und
eine Abschirmschicht (SHLD), die auf der zweiten Planarisierungsschicht (207) angeordnet ist.

13. Anzeigevorrichtung (1) nach Anspruch 12,
wobei die Abschirmschicht (SHLD) elektrisch mit den zweiten Stromleitungen (DCL2) verbunden ist; und/oder
wobei sich die Abschirmschicht (SHLD), aus einer Richtung senkrecht zum Substrat (100) betrachtet, mit der dritten Teilsignalleitung (LSL3) überlappt,.

14. Anzeigevorrichtung (1) nach einem der vorstehenden Ansprüche, die ferner Dummy-Leitungen (DML) umfasst, die zwischen den mehreren Leitungsgruppen angeordnet sind und aus dem gleichen Material wie jede der Datenleitungen (DL) bestehen.

15. Anzeigevorrichtung (1) nach Anspruch 14,
wobei sich ein Abschnitt der ersten Teilsignalleitung (LSL1), der sich mit den Dummy-Leitungen (DML) überlappt, in einer Richtung parallel zu den Dummy-Leitungen (DML) erstreckt, während sich ein anderer Abschnitt der ersten Teilsignalleitung (LSL1), der sich mit den Datenleitungen (DL) überlappt, in einer Richtung erstreckt, die die Datenleitungen (DL) kreuzt; und/oder
wobei sich die Dummy-Leitungen (DML), aus einer Richtung senkrecht zum Substrat (100) betrachtet, zwischen der zweiten Teilsignalleitung (LSL2) und den Datenleitungen (DL) befinden; und/oder
wobei sich die zweite Teilsignalleitung (LSL2), aus einer Richtung senkrecht zum Substrat (100) betrachtet, mit den Dummy-Leitungen (DML) überlappt, und wobei sich die zweite Teilsignalleitung (LSL2) in einer Richtung parallel zu den Dummy-Leitungen (DML) erstreckt.

## Revendications

1. Appareil d'affichage (1) comportant :
un substrat (100) comportant une zone d'affichage (DA) dans laquelle une diode électroluminescente (ED) et un capteur de lumière (LS) sont agencés et une zone périphérique (PA) en dehors de la zone d'affichage (DA) ;
des lignes de données (DL) dans la zone périphérique (PA) ; et
des lignes de signal de détection de lumière (LSL) comportant une première ligne de sous-signal (LSL1) dans la zone périphérique (PA), une troisième ligne de sous-signal (LSL3) espacée de la première ligne de sous-signal (LSL1) et positionnée plus près de la zone d'affichage (DA) que la première ligne de sous-signal (LSL1), et une deuxième ligne de sous-signal (LSL2) reliant la première ligne de sous-signal (LSL1) à la troisième ligne de sous-signal (LSL3),
dans lequel, lorsqu'elles sont vues depuis une direction perpendiculaire au substrat (100), les lignes de données (DL) sont divisées en une pluralité de groupes de lignes, et la deuxième ligne de sous-signal (LSL2) est entre la pluralité de groupes de lignes,
**caractérisé en ce que**
la deuxième ligne de sous-signal (LSL2) est disposée dans une couche différente de la première ligne de sous-signal (LSL1) et de la troisième ligne de sous-signal (LSL3).

2. Appareil d'affichage (1) selon la revendication 1, comportant en outre :
une couche isolante intercouche (205) disposée sur les lignes de données (DL) pour recouvrir les lignes de données (DL) ;
des premières lignes électriques (DCL1) disposées sur la couche isolante intercouche (205) ; et
une première couche de planarisation (206) agencée entre les premières lignes électriques (DCL1) et la première ligne de sous-signal (LSL1) pour recouvrir les premières lignes électriques (DCL1).

3. Appareil d'affichage (1) selon la revendication 2, dans lequel les premières lignes électriques (DCL1) sont entre la première ligne de sous-signal (LSL1) et les lignes de données (DL) dans une zone dans laquelle la première ligne de sous-signal (LSL1) chevauche les lignes de données (DL).

4. Appareil d'affichage (1) selon l'une quelconque des revendications précédentes, dans lequel le substrat (100) comporte une zone de courbure (BA) pour courber le substrat (100) de sorte qu'une partie de la zone périphérique (PA) chevauche la zone d'affichage (DA), et
la première ligne de sous-signal (LSL1) traverse la zone de courbure (BA).

5. Appareil d'affichage (1) selon la revendication 1, comportant en outre une première couche de planarisation (206) disposée sur les lignes de données (DL),
dans lequel, lorsqu'il est vu depuis une direction perpendiculaire au substrat (100), le substrat (100) comporte une zone de vallée (VA) s'étendant dans une première direction parallèle à une limite de la zone d'affichage (DA), et la première couche de planarisation (206) présente une ouverture chevauchant la zone de vallée (VA).

6. Appareil d'affichage (1) selon la revendication 5,
dans lequel, lorsqu'elle est vue depuis une direction perpendiculaire au substrat (100), la deuxième ligne de sous-signal (LSL2) traverse la zone de vallée (VA) ; et/ou
dans lequel la deuxième ligne de sous-signal (LSL2) est disposée sous la première couche de planarisation (206) ; et/ou
dans lequel la deuxième ligne de sous-signal (LSL2) comporte un même matériau que chacune des lignes de données (DL).

7. Appareil d'affichage (1) selon la revendication 5 ou 6, comportant en outre une couche isolante inorganique (201) sous les lignes de données (DL),
dans lequel la deuxième ligne de sous-signal (LSL2) est entre la couche isolante inorganique (201) et le substrat (100).

8. Appareil d'affichage (1) selon la revendication 1, comportant en outre une couche isolante intercouche (205) disposée sur les lignes de données (DL) pour recouvrir les lignes de données (DL) ;
des deuxièmes lignes électriques (DCL2) disposées sur la couche isolante intercouche (205) ; et
une première couche de planarisation (206) entre les deuxièmes lignes électriques (DCL2) et la troisième ligne de sous-signal (LSL3) pour recouvrir les deuxièmes lignes électriques (DCL2).

9. Appareil d'affichage (1) selon la revendication 8, dans lequel les deuxièmes lignes électriques (DCL2) sont entre la troisième ligne de sous-signal (LSL3) et les lignes de données (DL) dans une zone dans laquelle la troisième ligne de sous-signal (LSL3) chevauche les lignes de données (DL).

10. Appareil d'affichage (1) selon la revendication 8 ou 9, comportant en outre des lignes électriques horizontales (DCLh) agencées entre la couche isolante intercouche (205) et la première couche de planarisation (206) et positionnées plus proches de la zone d'affichage (DA) que les deuxièmes lignes électriques (DCL2),
dans lequel les lignes électriques horizontales (DCLh) s'étendent dans une première direction parallèle à une limite de la zone d'affichage (DA), lorsqu'elles sont vues dans une direction perpendiculaire au substrat (100).

11. Appareil d'affichage (1) selon la revendication 10, dans lequel la troisième ligne de sous-signal (LSL3) s'étend dans une deuxième direction perpendiculaire à la première direction dans une zone chevauchant les lignes électriques horizontales (DCLh).

12. Appareil d'affichage (1) selon l'une quelconque des revendications 8 à 11, comportant en outre :
une deuxième couche de planarisation (207) disposée sur la troisième ligne de sous-signal (LSL3) pour recouvrir la troisième ligne de sous-signal (LSL3) ; et
une couche de blindage (SHLD) disposée sur la deuxième couche de planarisation (207).

13. Appareil d'affichage (1) selon la revendication 12,
dans lequel la couche de blindage (SHLD) est connectée électriquement aux deuxièmes lignes électriques (DCL2) ; et/ou
dans lequel la couche de blindage (SHLD) chevauche la troisième ligne de sous-signal (LSL3), lorsqu'elle est vue depuis une direction perpendiculaire au substrat (100).

14. Appareil d'affichage (1) selon l'une quelconque des revendications précédentes, comportant en outre des lignes factices (DML) agencées entre la pluralité de groupes de lignes et comportant un même matériau que chacune des lignes de données (DL).

15. Appareil d'affichage (1) selon la revendication 14,
dans lequel une partie de la première ligne de sous-signal (LSL1), la partie chevauchant les lignes factices (DML), s'étend dans une direction parallèle aux lignes factices (DML), et une autre partie de la première ligne de sous-signal (LSL1), l'autre partie chevauchant les lignes de données (DL), s'étend dans une direction traversant les lignes de données (DL) ; et/ou
dans lequel les lignes factices (DML) sont entre la deuxième ligne de sous-signal (LSL2) et les lignes de données (DL), lorsqu'elles sont vues depuis une direction perpendiculaire au substrat (100) ; et/ou
dans lequel, lorsqu'elle est vue depuis une direction perpendiculaire au substrat (100), la deuxième ligne de sous-signal (LSL2) chevauche les lignes factices (DML), et la deuxième ligne de sous-signal (LSL2) s'étend dans une direction parallèle aux lignes factices (DML).
